# EUROPEAN PATENT SPECIFICATION

(11) **EP 4 495 734 B1**
(45) Date of publication and mention of the grant of the patent: **04.11.2026**
(21) Application number: 24711777.3
(22) Date of filing: 08.03.2024
(51) Int. Cl.: G06F 1/16, G06F 1/18, C09J 7/00, G09F 9/30, C09J 9/00

(54) **ELECTRONIC DEVICE INCLUDING FOREIGN MATTER PREVENTION PART**
ELEKTRONISCHE VORRICHTUNG MIT STRUKTUR ZUR VERHINDERUNG VON FREMDSTOFFEN
DISPOSITIF ÉLECTRONIQUE COMPRENANT UNE PARTIE DE PRÉVENTION DE MATIÈRE ÉTRANGÈRE

(30) Priority: 02.06.2023 KR 20230071483; 10.07.2023 KR 20230089428
(43) Date of publication of application: 22.01.2025
(73) Proprietor: Samsung Electronics Co., Ltd., Suwon-si, Gyeonggi-do 16677 (KR)
(72) Inventor: JANG, Seokmin, Suwon-si Gyeonggi-do 16677 (KR); KIM, Bongsoo, Suwon-si Gyeonggi-do 16677 (KR); BYUN, Wanju, Suwon-si Gyeonggi-do 16677 (KR); LEE, Wonho, Suwon-si Gyeonggi-do 16677 (KR); CHO, Sujeong, Suwon-si Gyeonggi-do 16677 (KR); JIN, Myoungdae, Suwon-si Gyeonggi-do 16677 (KR)
(74) Representative: Appleyard Lees IP LLP
(86) International application number: PCT/KR2024/003049
(87) International publication number: WO 2024/248284

(56) References cited:
- KR-A- 20050 027 491
- KR-A- 20100 057 531
- KR-A- 20220 015 310
- KR-A- 20220 071 846
- KR-A- 20220 078 197
- KR-A- 20220 137 422
- US-A1- 2022 317 739

## Description

### [Technical Field]

The following descriptions relate to an electronic device including a foreign matter prevention part.

### [Background Art]

An electronic device including a large-screen display may increase user utilization thereof. As a demand for highly portable electronic devices increases, the electronic device may include a deformable display. The deformable display may be slidably deformable, foldably deformable, or rollably deformable. The electronic device may include a structure for reducing the inflow of foreign matter into a gap between the deformable display and the housing. The structure may contact at least a portion of the deformable display. The display may be deformed in a state of contacting the structure.

The above-described information is provided as a related art for the purpose of helping understand the present disclosure. No claim or determination is raised as to whether any of the above-described information may be applied as a prior art related to the present disclosure.

US 2022/317739 A1 discloses a portable device with a slidably extendable portion and a rollable display and a sweeping device to remove debris from the space into which the screen is stowed.

KR 2022 0078197 A discloses a portable device with a slidably extendable portion and a rollable display with grounding means for the display to eliminate static.

### [Disclosure]

### [Technical Solution]

An electronic device is provided. The electronic device comprises a housing. The electronic device comprises a display including a first area, and a second area at least partially bendable into the housing. The electronic device comprises a foreign matter prevention part coupled to the housing, and disposed between a surface of the second area for displaying visual information and the housing. The foreign matter prevention part includes a surface coupled to the housing, another surface opposite to the surface of the foreign matter prevention part and contacted with the surface of the second area, and a conductive portion electrically connected to the housing to discharge static electricity.

An electronic device is provided. The electronic device may comprise a first housing, a second housing, a display, and a foreign matter prevention part. The second housing may be slidably coupled to the first housing. The display may include a surface for displaying visual information and another surface opposite to the surface. The display may include an area at least partially bendable into the housing, based on a slide movement of the second housing. The foreign matter prevention part may be disposed between the surface in the area and the first housing, in a state in which the area is rolled into the first housing. The foreign matter prevention part may be configured to reduce the inflow of foreign matter through the gap between the display and the first housing, by being coupled to the first housing. The foreign matter prevention part may include a conductive portion and non-conductive portion. The conductive portion may be electrically connected to the housing so that static electricity is discharged.

The invention is defined by the appended claims.

### [Description of the Drawings]

The subject-matter of the present disclosure is best understood with reference to the accompanying figures, in which:
FIG. 1 is a block diagram illustrating an electronic device 101 in a network environment 100 according to various embodiments.
FIG. 2A is a top plan view of the electronic device in a first state according to various embodiments.
FIG. 2B is a bottom view of the electronic device of FIG. 2A in a first state.
FIG. 2C is a top plan view of the electronic device of FIG. 2A in a second state.
FIG. 2D is a bottom view of the electronic device of FIG. 2A in a second state.
FIGS. 3A and 3B are exploded perspective views of an electronic device according to various embodiments.
FIG. 4A is a cross-sectional view of an electronic device in a first state according to various embodiments.
FIG. 4B is a cross-sectional view of the electronic device of FIG. 4A in a second state.
FIG. 5A illustrates a portion of an electronic device in a first state according to various embodiments.
FIG. 5B illustrates a portion of the electronic device of FIG. 5A in a second state.
FIG. 5C illustrates a portion of the electronic device of FIG. 5A in a first state.
FIG. 6 illustrates an electronic device in which a display is omitted.
FIG. 7A is a partial cross-sectional view of the electronic device of FIG. 2A cut along A-A'.
FIG. 7B illustrates the electronic device of FIG. 7A in which a display is omitted.
FIG. 7C illustrates a foreign matter prevention part.
FIGS. 7D and 7E illustrate a portion of an electronic device in a first state.
FIG. 7F is an enlarged view of a portion of an electronic device.
FIG. 7G illustrates an electronic device.
FIG. 8A illustrates an unfolding state of an electronic device.
FIG. 8B illustrates a folding state of an electronic device.
FIG. 9A is an exploded perspective view of an electronic device.
FIG. 9B is a cross-sectional view of the electronic device of FIG. 8A cut along B-B'.

### [Mode for Invention]

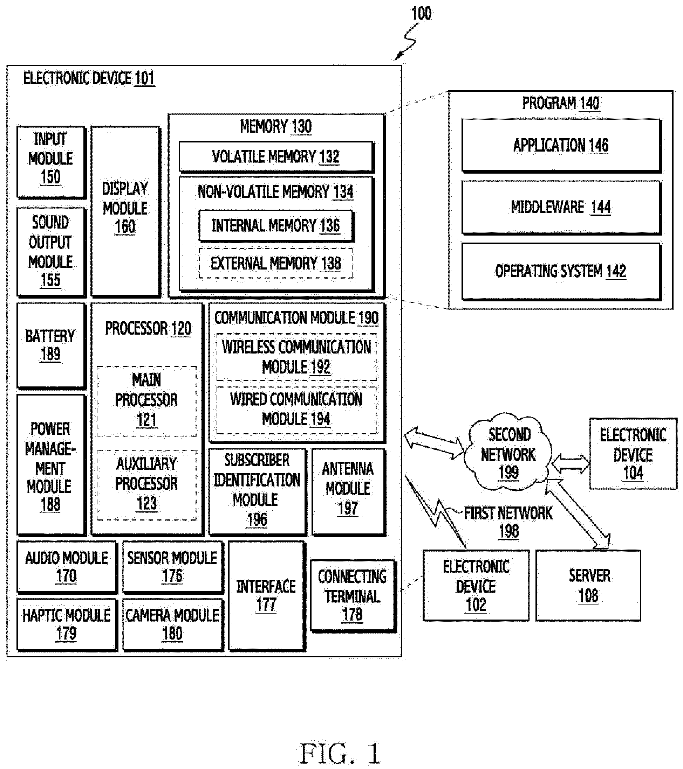

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108, via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to perform a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such machine learning may be performed, e.g., by the electronic device 101 on which the artificial intelligence model processing is performed, or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or via the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may comprise a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

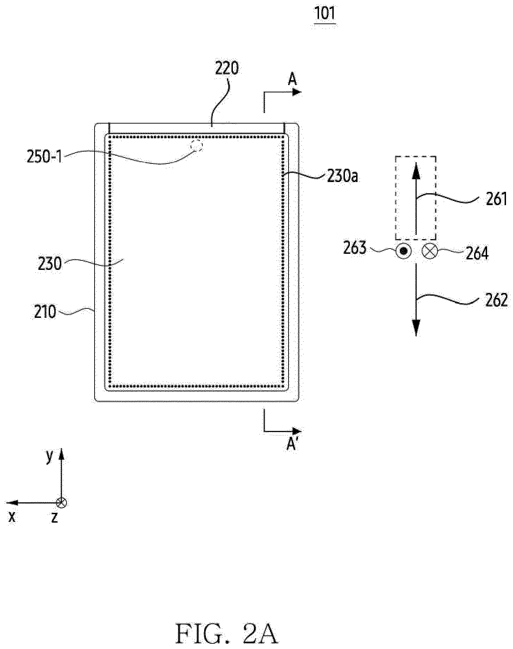

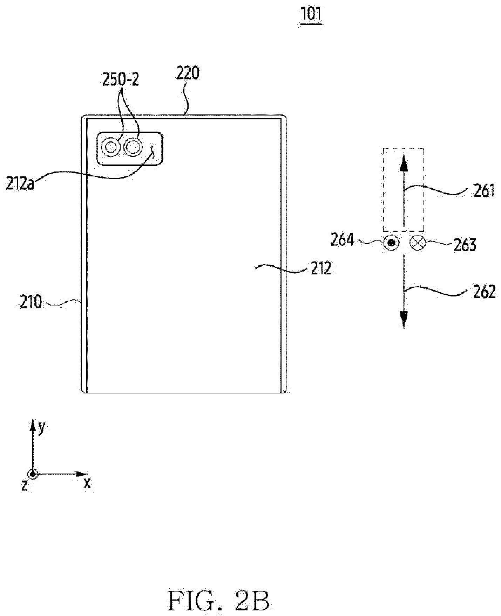

For example, a display of the display module 160 may be flexible. For example, the display may include a display area exposed outside a housing of the electronic device 101 that provides at least a portion of an outer surface of the electronic device 101. For example, since the display has flexibility, at least a portion of the display may be rollable into the housing or may be slidable into the housing. For example, a size of the display area may be changed according to a size of at least a portion of the display rolled into the housing or slid into the housing. For example, the electronic device 101 including the display may be in a plurality of states including a first state providing the display area having a first size and a second state providing the display area having a second size different from the first size. For example, the first state may be exemplified through a description of FIGS. 2A and 2B.

FIG. 2A is a top plan view of the electronic device in a first state according to various embodiments.

Referring to FIG. 2A, an electronic device 101 may include a first housing 210, a second housing 220 movable with respect to the first housing 210 in a first direction 261 parallel to a y-axis or a second direction 262 parallel to the y-axis and opposite to the first direction 261, and a display 230.

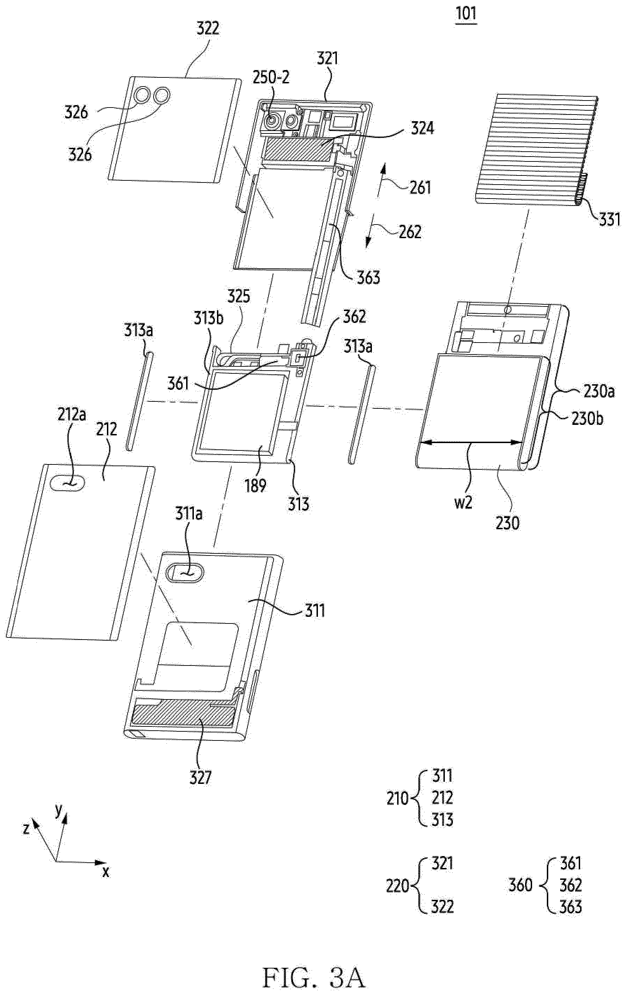

Hereinafter, an operation in which the second housing 220 is moved with respect to the first housing 210 will be described, but it is not limited thereto. For example, the electronic device 101 may have a structure in which an overall size of the electronic device 101 may be changed according to a change in relative positional relationship between the first housing 210 and the second housing 220. For example, the relative positional relationship between the first housing 210 and the second housing 220 may be changed by an operation of a driving unit (e.g., a driving unit 360 of FIG. 3A), which will be described later. For example, by the driving unit 360, the first housing 210 or the second housing 220 may move, or both the first housing 210 and the second housing 220 may move.

For example, the electronic device 101 may be in the first state. For example, in the first state, the second housing 220 may be substantially movable with respect to the first housing 210 in the first direction 261 of the first direction 261 and the second direction 262. For example, in the first state, the second housing 220 may not be substantially movable in the second direction 262 with respect to the first housing 210.

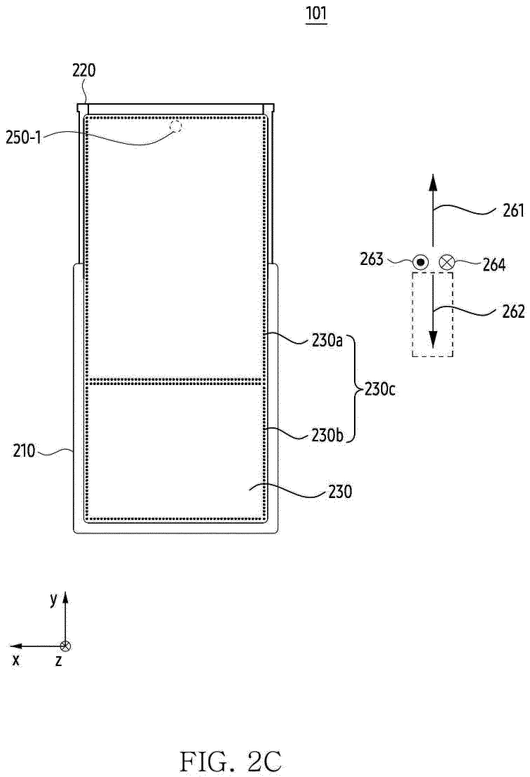

For example, in the first state, the display 230 may provide the display area having the smallest size. For example, in the first state, the display area may correspond to an area 230a. For example, although not illustrated in FIG. 2A, in the first state, an area (e.g., an area 230b of FIG. 2C) of the display 230 different from the area 230a, which is the display area, may be included in the first housing 210. For example, in the first state, the area (e.g., the area 230b of FIG. 2C) may be covered by the first housing 210. For example, in the first state, the area may be rollable into the first housing 210. For example, in the first state, the area 230a may include a planar portion. However, it is not limited thereto. For example, in the first state, the area 230a may include a curved portion (or bent portion) extending from the planar portion and located in an edge portion.

For example, the first state may be referred to as a slid-in state or a closed state in terms of at least a portion of the second housing 220 being located in the first housing. For example, the first state may be referred to as a reduced state in terms of providing the display area having the smallest size.

For example, the second housing 220 may include a first image sensor 250-1 in a camera module 180 exposed through a portion of the area 230a and facing a third direction 263 parallel to a z-axis. For example, although not illustrated in FIG. 2A, the second housing 220 may include one or more second image sensors in the camera module 180 exposed through a portion of the second housing 220 and facing a fourth direction 264 parallel to the z-axis and opposite the third direction 263. For example, the one or more second image sensors may be exemplified through a description of FIG. 2B.

FIG. 2B is a bottom view of the electronic device of FIG. 2A in a first state.

Referring to FIG. 2B, in the first state, one or more second image sensors 250-2 disposed in a second housing 220 may be located within a structure, such as an opening or notch, disposed in a first housing 210 for the one or more second image sensors 250-2. For example, light from outside of the electronic device 101 may be received by the one or more second image sensors 250-2 through the structure in the first state. For example, since the one or more second image sensors 250-2 are located within the structure in the first state, the one or more second image sensors 250-2 may be exposed through the structure in the first state. The structure may be implemented in various ways, for example, the structure may be an opening 212a in a first plate 212 of the first housing 210 that surrounds at least a portion of the second housing 220. However, it is not limited thereto, for example, in the first state, the one or more second image sensors 250-2 included in the second housing 220 may be covered by the first plate 212 of the first housing 210.

Referring to FIG. 1, the first state may be changed to the second state.

For example, the first state (or the second state) may be changed to the second state (or the first state) through intermediate states between the first state and the second state.

For example, the first state (or the second state) may be changed to the second state (or the first state) based on a user input. For example, the first state (or the second state) may be changed to the second state (or the first state) in response to a user input to a physical button exposed through a portion of the first housing 210 or a portion of the second housing 220. For example, the first state (or the second state) may be changed to the second state (or the first state) in response to a touch input for an executable object displayed in the display area. For example, the first state (or the second state) may be changed to the second state (or the first state) in response to a touch input having a contact point on the display area and having a pressing intensity of greater than or equal to a reference intensity. For example, the first state (or the second state) may be changed to the second state (or the first state) in response to a voice input received through a microphone of the electronic device 101. For example, the first state (or the second state) may be changed to the second state (or the first state) in response to an external force applied to the first housing 210 or the second housing 220 for moving the second housing 220 with respect to the first housing 210. For example, the first state (or the second state) may be changed to the second state (or the first state) in response to a user input identified in an external electronic device (e.g., earbuds or smart watch) connected to the electronic device 101. However, it is not limited thereto.

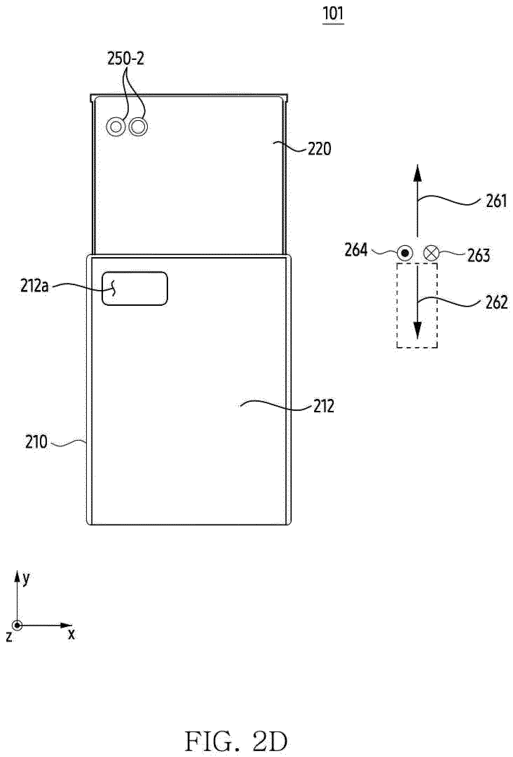

The second state may be exemplified through a description of FIGS. 2C and 2D.

FIG. 2C is a top plan view of the electronic device in a second state.

Referring to FIG. 2C, an electronic device 101 may be in the second state. For example, in the second state, the second housing 220 may be movable with respect to the first housing 210 in the second direction 262 of a first direction 261 and the second direction 262. For example, in the second state, the second housing 220 may not be movable in the first direction 261 with respect to the first housing 210.

For example, in the second state, the display 230 may provide the display area having the largest size. For example, in the second state, the display area may correspond to an area 230c including the area 230a and the area 230b. For example, the area 230b included in the first housing 210 in the first state may be exposed in the second state. For example, in the second state, the area 230a may include a planar portion. However, it is not limited thereto. For example, the area 230a may include a curved portion extending from the planar portion and located in an edge portion. For example, in the second state, the area 230b, unlike the area 230a in the first state, may include the planar portion of the planar portion and the curved portion. However, it is not limited thereto. For example, the area 230b may include the curved portion extending from the planar portion of the area 230b and located in the edge portion.

For example, the second state may be referred to as a slid-out state or an open state in terms of extending at least a portion of the second housing 220 disposed outside the first housing 210, with respect to the first state. For example, the second state may be referred to as an extended state in terms of providing the display area having the largest size. However, it is not limited thereto.

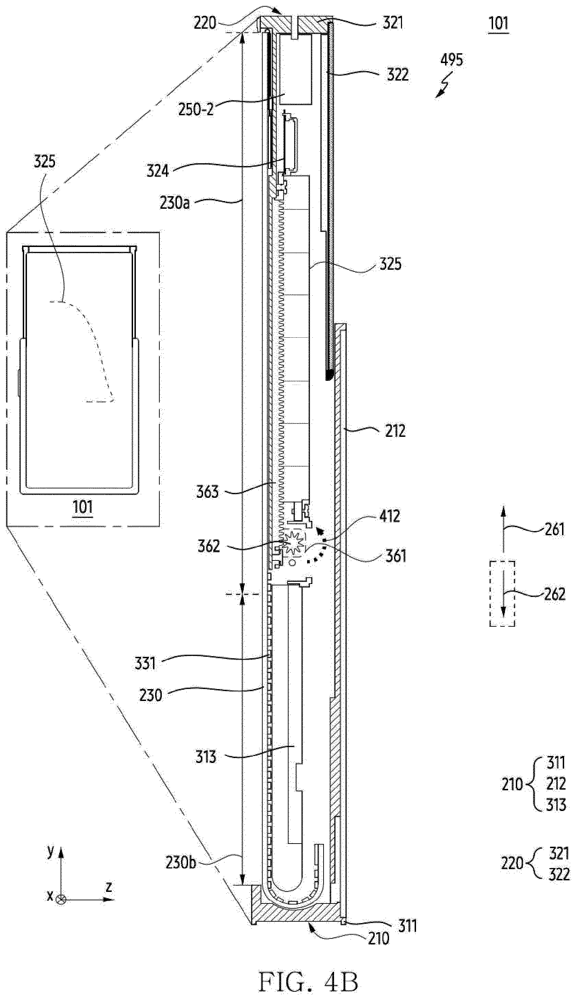

For example, when a state of the electronic device 101 changes from the first state to the second state, a first image sensor 250-1 facing a third direction 263 may move together with the area 230a according to the movement of the second housing 220 in the first direction 261. For example, although not illustrated in FIG. 2C, one or more second image sensors 250-2 facing a fourth direction 264 may be moved according to the movement of the second housing 220 in the first direction 261 when the state of the electronic device 101 changes from the first state to the second state. For example, relative positional relationship between the one or more second image sensors 250-2 and the structure, such as the opening or notch, exemplified through a description of FIG. 4B, may change according to the movement of the one or more second image sensors 250-2. For example, the change in the relative positional relationship may be illustrated through FIG. 2D.

FIG. 2D is a bottom view of the electronic device of FIG. 2A in a second state.

Referring to FIG. 2D, in the second state, one or more second image sensors 250-2 may be located outside the structure. For example, the structure may include an opening 212a. For example, in the second state, the one or more second image sensors 250-2 may be located outside the opening 212a in a first plate 212. For example, the one or more second image sensors 250-2 may be exposed through the opening 212a in a first state. For example, since the one or more second image sensors 250-2 are located outside a first housing 210 in the second state, the one or more second image sensors 250-2 may be exposed in the second state. For example, since the one or more second image sensors 250-2 are located the outside the structure in the second state, relative positional relationship in the second state may be different from relative positional relationship in the first state.

For example, in cases in which the electronic device 101 does not include the structure such as the opening 212a, the one or more second image sensors 250-2 may be exposed in the second state.

Although not illustrated in FIGS. 2A, 2B, 2C, and 2D, the electronic device 101 may be in an intermediate state between the first state and the second state. For example, a size of the display area in the intermediate state may be larger than a size of the display area in the first state and smaller than a size of the display area in the second state. For example, the display area in the intermediate state may correspond to an area including an area 230a and a portion of an area 230b. For example, in the intermediate state, a portion of the area 230b is exposed, and another portion (or remaining portion) of the area 230b may be covered by the first housing 210 or may be rolled into the first housing 210. However, it is not limited thereto.

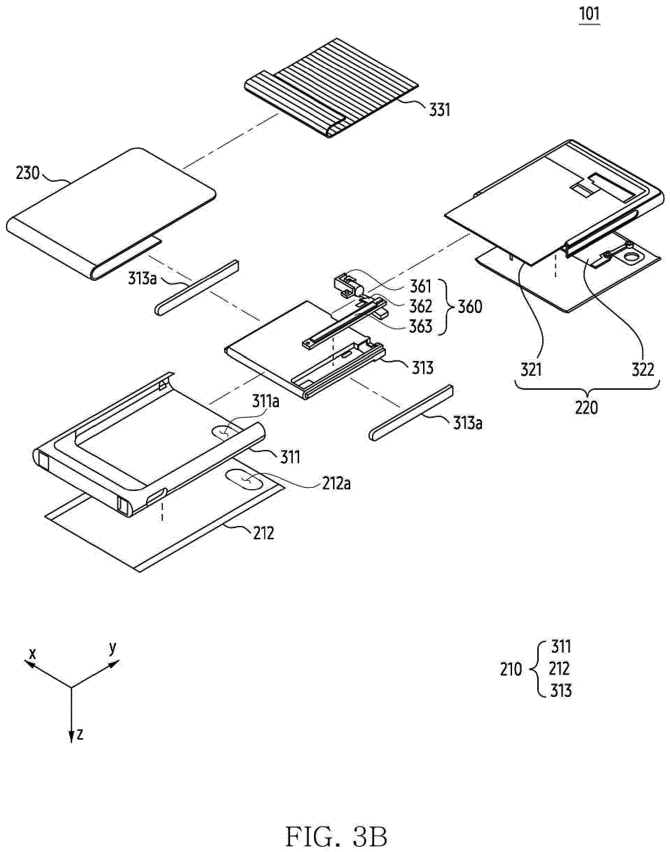

The electronic device 101 may include structures for moving a second housing (e.g., a second housing 220 of FIG. 2A) of the electronic device 101 with respect to the first housing (e.g., a first housing 210 of FIG. 2A) of the electronic device 101. For example, the structures may be exemplified through a description of FIGS. 3A and 3B.

FIGS. 3A and 3B are exploded perspective views of an electronic device according to various embodiments.

Referring to FIGS. 3A and 3B, an electronic device 101 may include a first housing 210, a second housing 220, a display 230, and a driving unit 360.

For example, the first housing 210 may include a first cover 311, a first plate 212, and a frame 313.

For example, the first cover 311 may at least partially form a side surface portion of an outer surface of the electronic device 101. For example, the first cover 311 may include an opening 311a for one or more second image sensors 250-2. For example, the first cover 311 may include a surface supporting the first plate 212. For example, the first cover 311 may be coupled to the first plate 212. For example, the first cover 311 may include the frame 313. For example, the first cover 311 may be coupled to the frame 313.

For example, the first plate 212 may at least partially form a rear surface portion of the outer surface. For example, the first plate 212 may include an opening 212a for the one or more second image sensors 250-2. For example, the first plate 212 may be disposed on the surface of the first cover 311. For example, the opening 212a may be aligned with the opening 311a.

For example, the frame 313 may be at least partially surrounded by the first cover 311.

For example, the frame 313 may be at least partially surrounded by the display 230. For example, the frame 313 is at least partially surrounded by the display 230, but a position of the frame 313 may be maintained independently of a movement of the display 230. For example, the frame 313 may be arranged in relation to at least some of components of the display 230. For example, the frame 313 may include rails 313a that provide (or guide) a path of a movement of at least one component of the display 230. In this disclosure, a component may be referred to as an electronic component for providing one or more functions, and a structure may be referred to as a physical part for providing one or more functions.

For example, the frame 313 may be coupled to at least one component of the electronic device 101. For example, the frame 313 may support a battery 189. For example, the battery 189 may be supported through a recess or hole in a surface 313b of the frame 313. For example, the frame 313 may be coupled to one end of a flexible printed circuit board (FPCB) 325 on a surface of the frame 313. For example, although not explicitly illustrated in FIGS. 3A and 3B, another end of the FPCB 325 may be connected to a PCB 324 through at least one connector. For example, the PCB 324 may be electrically connected to another PCB (not illustrated in FIGS. 3A and 3B) that supplies power to a motor 361 through the FPCB 325.

For example, the frame 313 may be coupled to at least one structure of the electronic device 101 for the plurality of states including the first state and the second state. For example, the frame 313 may be fastened to the motor 361 of the driving unit 360.

For example, the second housing 220 may include a second cover 321 and a second plate 322.

For example, the second cover 321 may be at least partially surrounded by the display 230. For example, the second cover 321 may be coupled to at least a portion of an area 230a of the display 230 that surrounds the second cover 321, unlike the frame 313, so that the display 230 moves according to the second housing 220 that is moved with respect to the first housing 210.

For example, the second cover 321 may be coupled to the at least one component of the electronic device 101. For example, the second cover 321 may be coupled to the printed circuit board (PCB) 324 including components of the electronic device 101. For example, the PCB 324 may include a processor 120 (not illustrated in FIGS. 3A and 3B). For example, the second cover 321 may support the one or more second image sensors 250-2.

For example, the second cover 321 may be coupled to the at least one structure of the electronic device 101 for the plurality of states including the first state and the second state. For example, the second cover 321 may be fastened to a rack gear 363 of the driving unit 360.

For example, the second cover 321 may be coupled to the second plate 322.

For example, the second plate 322 may be coupled to the second cover 321, in order to protect at least one component of the electronic device 101 coupled in the second cover 321 or at least one structure of the electronic device 101 coupled in the second cover 321. For example, the second plate 322 may include a structure for the at least one component. For example, the second plate 322 may include one or more openings 326 for the one or more second image sensors 250-2. For example, the one or more openings 326 may be aligned with the one or more second image sensors 250-2 disposed on the second cover 321. For example, a size of each of the one or more openings 326 may correspond to a size of each of the one or more second image sensors 250-2.

For example, the electronic device 101 may include a support member 331 for supporting at least a portion of the display 230. For example, the support member 331 may include a plurality of bars. For example, the plurality of bars may be coupled to each other. The support member 331 may support an area 230b of the display 230.

For example, the driving unit 360 may include the motor 361, a pinion gear 362, and the rack gear 363.

For example, the motor 361 may operate based on power from the battery 189. For example, the power may be provided to the motor 361 in response to the user input.

For example, the pinion gear 362 may be coupled to the motor 361 through a shaft. For example, the pinion gear 362 may be rotated based on the operation of the motor 361 transmitted through the shaft.

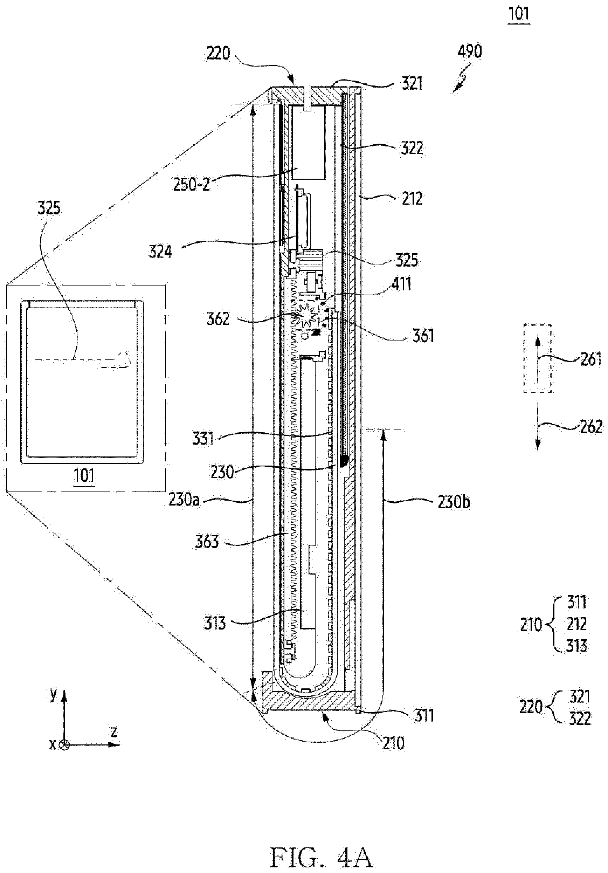

For example, the rack gear 363 may be arranged in relation to the pinion gear 362. For example, teeth of the rack gear 363 may engage with teeth of the pinion gear 362. For example, the rack gear 363 may be moved in a first direction 261 or a second direction 262 according to the rotation of the pinion gear 362. For example, the second housing 220 may be moved in the first direction 261 and the second direction 262 by the rack gear 363 that is moved according to the rotation of the pinion gear 362 due to the operation of the motor 361. For example, the first state of the electronic device 101 may be changed to a state (e.g., the one or more intermediate states or the second state) different from the first state through the movement of the second housing 220 in the first direction 261. For example, the second state of the electronic device 101 may be changed to a state (e.g., the one or more intermediate states or the first state) different from the second state through the movement of the second housing 220 in the second direction 262. For example, the change of the first state to the second state by the driving unit 360 and the change of the second state to the first state by the driving unit 360 may be exemplified through FIGS. 4A and 4B.

FIG. 4A is a cross-sectional view of an electronic device in a first state according to various embodiments. FIG. 4B is a cross-sectional view of the electronic device of FIG. 4A in a second state.

Referring to FIGS. 4A and 4B, a motor 361 may operate based at least in part on the above-defined user input received in a state 490 which is a first state. For example, a pinion gear 362 may be rotated in a first rotation direction 411 based at least in part on the operation of the motor 361. For example, a rack gear 363 may be moved in a first direction 261 based at least in part on the rotation of the pinion gear 362 in the first rotation direction 411. For example, since a second cover 321 in a second housing 220 is fastened to the rack gear 363, the second housing 220 may be moved in the first direction 261 based at least in part on the movement of the rack gear 363 in the first direction 261. For example, since the second cover 321 in the second housing 220 is coupled to at least a portion of an area 230a of a display 230 and is fastened to the rack gear 363, the display 230 may be moved based at least in part on the movement of the rack gear 363 in the first direction 261. For example, the display 230 may be moved along rails 313a of FIG. 3A. For example, a shape of at least some of the plurality of bars of a support member 331 of the display 230 may be changed when the first state 490 is changed to a state 495 which is the second state.

For example, an area 230b of the display 230 may be moved according to the movement of the display 230. For example, when the first state 490 is changed to the second state 495 according to the above-defined user input, the area 230b may be moved through a space between a first cover 311 and a frame 313. For example, in the second state 495, the area 230b is exposed, whereas in the first state 490, the area 230b is rolled into the space between the first cover 311 and the frame 313.

For example, since the second cover 321 in the second housing 220 is coupled to a PCB 324 connected to the other end of a FPCB 325 and is fastened to the rack gear 363, a shape of the FPCB 325 may be changed when the first state 490 is changed to the second state 495.

The motor 361 may be operated based at least in part on the user input received in the second state 495. For example, the pinion gear 362 may be rotated in a second rotation direction 412 based at least in part on the operation of the motor 361. For example, the rack gear 363 may be moved in the second direction 262 based at least in part on the rotation of the pinion gear 362 in the second rotation direction 412. For example, since the second cover 321 in the second housing 220 is fastened to the rack gear 363, the second housing 220 may be moved in the second direction 262, based at least in part on the movement of the rack gear 363 in the second direction 262. For example, since the second cover 321 of the second housing 220 is coupled to the at least a portion of the area 230a of the display 230 and is fastened to the rack gear 363, the display 230 may be moved based at least in part on the movement of the rack gear 363 in the second direction 262. For example, the display 230 may be moved along the rails 313a. For example, the shape of the at least some of the plurality of bars of the support member 331 of the display 230 may be changed when the second state 495 is changed to the first state 490. The support member 331 may be moved with respect to the first housing 210. The support member 331 stored inside the first housing 210 in the first state 490 may be located between the first cover 311 and the frame 313. The display 230 may be moved with respect to the first housing 210 according to movement of the support member 331.

For example, the area 230b of the display 230 may be moved according to the movement of the display 230. For example, when the second state 495 is changed to the first state 490 according to the user input, the area 230b may be moved through the space between the first cover 311 and the frame 313. For example, in the first state 490, the area 230b is rolled into the space between the first cover 311 and the frame 313, whereas in the second state 495, the area 230b is exposed.

For example, since the second cover 321 of the second housing 220 is coupled to the PCB 324 connected to the other end of the FPCB 325 and is fastened to the rack gear 363, the shape of the FPCB 325 may change when the second state 495 is changed to the first state 490.

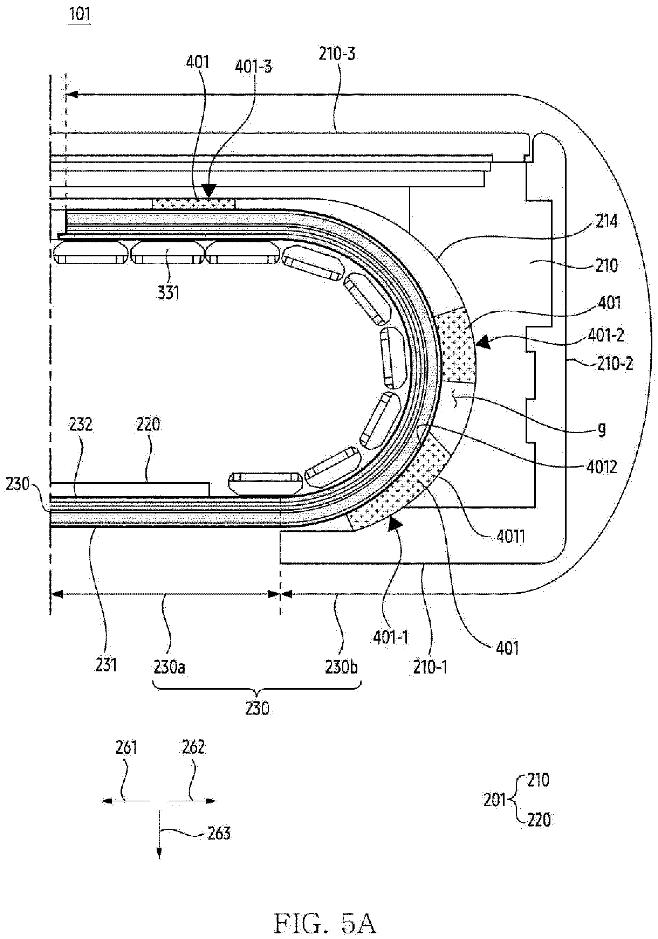

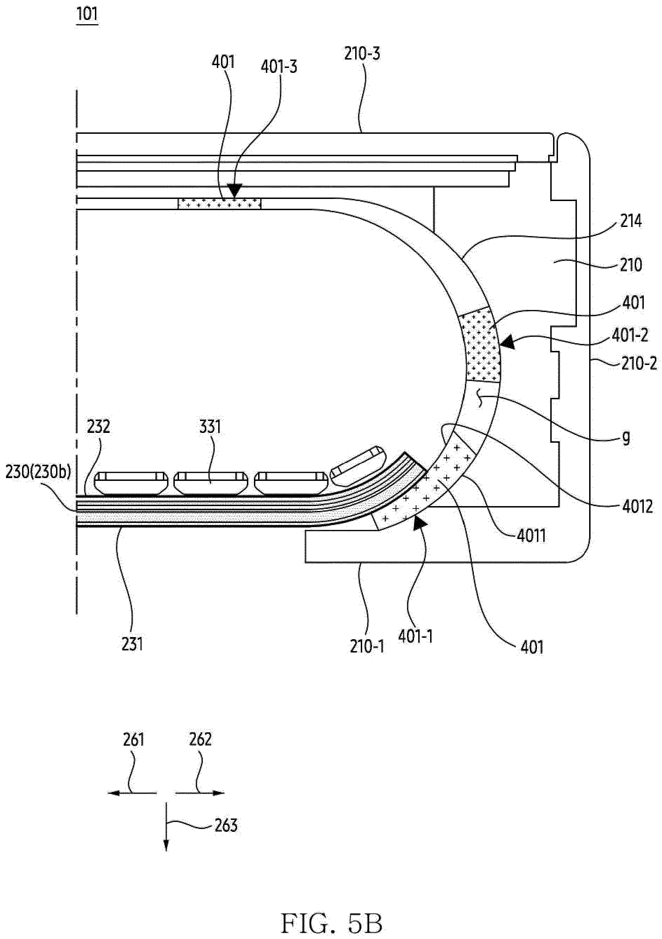

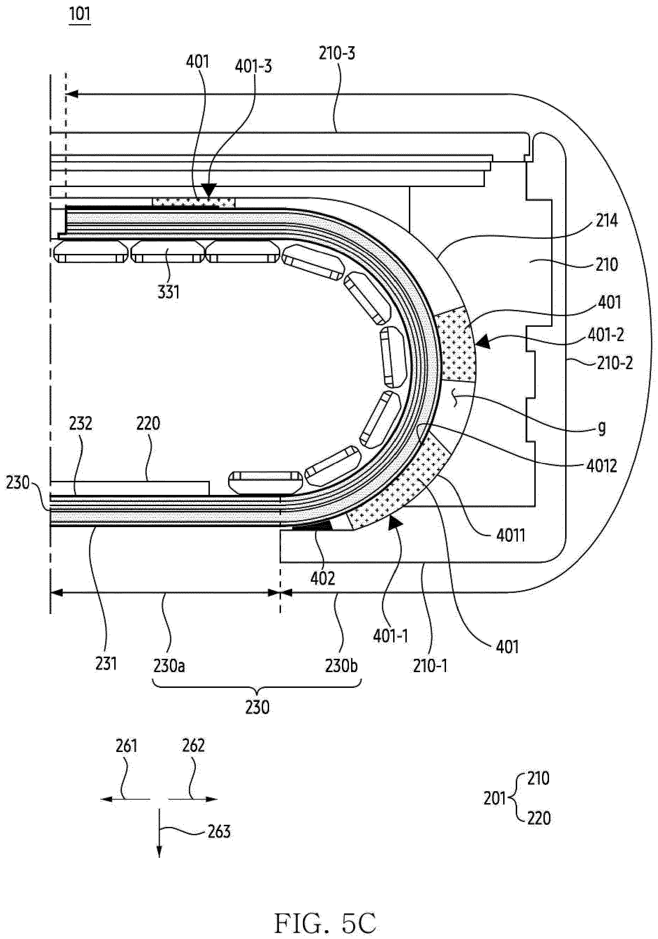

FIG. 5A illustrates a portion of an electronic device in a first state according to various embodiments. FIG. 5B illustrates a portion of the electronic device of FIG. 5A in a second state. FIG. 5C illustrates a portion of the electronic device of FIG. 5A in a first state.

Referring to FIGS. 5A and 5B, an exemplary electronic device 101 may include a housing 201, a display 230, and a foreign matter prevention part 401 (e.g., a sweeper). For example, the sweeper may contact the display 230 while coupled to the housing 201, and may sweep the display 230 based on moving the display 230.

The housing 201 may form an exterior of the electronic device 101. For example, the housing 201 may include a first housing 210 and a second housing 220. For example, the second housing 220 may be movably coupled to the first housing 210. The second housing 220 may be coupled to the first housing 210 to be movable in a first direction 261 and a second direction 262. The first housing 210 and the second housing 220 may be the first housing 210 and the second housing 220 as described with reference to FIGS. 2A to 4B. A state in which the second housing 220 is movable in the first direction 261 (e.g., a slid-in state) may be referred to as the first state illustrated in FIGS. 2A, 2B, and 5A. A state in which the second housing 220 is movable in the second direction 262 (e.g., a slid-out state) may be referred to as the second state illustrated in FIGS. 2C, 2D, and 5B.

According to an example, the display 230 may include a surface 231 and another surface 232. For example, the surface 231 may include a display area of the display 230 displaying visual information. For example, the surface 231 may be referred to as a front surface of the display 230 that may be visually recognized from outside by being exposed to the outside of the electronic device 101. A user of the electronic device 101 may visually recognize a visual object displayed in a display area in the surface 231. The other surface 232 may be opposite to the surface 231. In other words, the surfaces may face one another. In other words, the surfaces may be substantially parallel. For example, the other surface 232 may be supported by a support member 331. For example, the other surface 232 may be referred to as a rear surface of the display 230 that is not exposed to the outside of the electronic device 101. In effect, the other surface 232 is an inner surface of the display 230.

According to an example, the display 230 may include a first area 230a and a second area 230b. The first area 230a may be a portion of the display 230 that may always be visually recognized from the outside, independent of a state of the electronic device 101. For example, regardless of whether the electronic device 101 is in the first state or the second state, the first area 230a may be a flat planar portion. The second area 230b may be a bendable portion that may be at least partially deformed according to a movement of the second housing 220. For example, the display 230 may be coupled to the second housing 220. The display 230 may be configured to move based on the movement of the second housing 220. As illustrated in FIG. 5A, in the first state, at least a portion of the second area 230b may be bent into the first housing 210. As illustrated in FIG. 5B, in the second state, at least a portion of the second area 230b may be unfolded. As the display 230 moves, a position of the second area 230b may change. For example, in the first state, the second area 230b may be located inside the first housing 210. For example, in the second state, at least a portion of the second area 230b may be located outside the first housing 210. When the second area 230b is located the outside the first housing 210, the second area 230b is unfolded, so that the display area of the display 230 is expanded. For example, the first area 230a may be referred to as the area 230a of FIG. 2A, and the second area 230b may be referred to as the area 230b of FIG. 2C.

According to an example, the first housing 210 may cover at least a portion of the second area 230b. For example, the first housing 210 may include a first surface 210-1 facing a direction 263 in which the first area 230a faces, a second surface 210-2 perpendicular to the first surface 210-1, and a third surface 210-3 opposite to the first surface 210-1. For example, the first surface 210-1 may be referred to as a front surface of the first housing 210. For example, the second surface 210-2 may be referred to as a bottom surface of the first housing 210. For example, the third surface 210-3 may be referred to as a rear surface of the first housing 210. However, it is not limited thereto. The first surface 210-1 may have a smaller area than the display area so that the display area of the display 230 may be visually recognized by being exposed. For example, an area of the first surface 210-1 may be smaller than an area of the third surface 210-3. As the display 230 moves, the second area 230b may be rolled into the first housing 210 or may move from the inside of the first housing 210 to the outside of the first housing 210. Advantageously, since the position of the second area 230b may be changed according to the movement of the second housing 220, in order to reduce damage to the second area 230b due to contact between the first housing 210 and the second area 230b when the display 230 moves, the first housing 210 may be spaced apart from the display 230. For example, a gap g may be formed between the first housing 210 and the second area 230b.

According to an example, the foreign matter prevention part 401 may be provided to reduce the inflow of foreign matter (e.g., dust) into the electronic device 101, or at least a portion of the electronic device 101, through the gap g. The foreign matter prevention part 401 may reduce the inflow of the foreign matter into the housing 201 through the gap g, by being disposed between the surface 231 in the second area 230b and the first housing 210. For example, the first housing 210 may include a recess 214 for accommodating the second area 230b, the foreign matter prevention part 401 may be disposed at a position (e.g., a first position 401-1) where the second area 230b is rolled into the recess 214. For example, the position where the second area 230b is rolled into the recess 214 may be a portion where an inner surface of the first housing 210 forming the recess 214 is curved or bent to correspond to the shape of the second area 230b, but is not limited thereto. For example, the electronic device 101 may include one or more foreign matter prevention part(s) 401. For example, as illustrated in FIG. 5A, when the electronic device 101 is in the first state, the foreign matter prevention part 401 may be disposed at a position (e.g., a second position 401-2) in which it contacts at least a portion of a bent portion (or curved portion) of the second area 230b. For example, when the electronic device 101 is in the first state, the foreign matter prevention part 401 may be disposed at a position (e.g., a third position 401-3) in which it contacts at least a portion of a flat portion of the second area 230b. The foreign matter prevention part 401 may be disposed in at least one of the first position 401-1, the second position 401-2, or the third position 401-3.

The foreign matter prevention part 401 may include a surface 4011 and another surface 4012 opposite to the surface 4011. The surface 4011 of the foreign matter prevention part 401 may be coupled to the first housing 210 so that the foreign matter prevention part 401 may reduce the inflow of the foreign matter through the gap g. For example, the surface 4011 of the foreign matter prevention part 401 is coupled to the first housing 210, and another surface 4012 of the foreign matter prevention part 401 opposite to the surface 4011 may contact the surface 231, which is the front surface of the display 230 in the second area 230b.

At least a portion of the second area 230b may move in a state of contacting the foreign matter prevention part 401. Since the foreign matter prevention part 401 is fastened or coupled to the first housing 210, the other surface 4012 of the foreign matter prevention part 401 may maintain contact with the second area 230b while the display 230 moves. When the display 230 moves, as at least a portion of the second area 230b moves in the state of contacting the foreign matter prevention part 401, friction may occur between the second area 230b and the foreign matter prevention part 401. Since the display 230 and the foreign matter prevention part 401 include different materials, static electricity due to friction between the second area 230b and the foreign matter prevention part 401 may be generated. For example, while the electronic device 101 is changed from the first state to the second state, the second area 230b may move in the state of contacting the foreign matter prevention part 401. As the second area 230b moves while in contact with the foreign matter prevention part 401, the materials included in the display 230 and the materials included in the foreign matter prevention part 401 are charged, respectively, and the static electricity may be generated. In some instances, charged air particles may flow into the inside of the housing 201 from the outside of the housing 210 through the gap g. For example, in a dry environment, air particles may be charged. The charged air particles may flow into the inside of the first housing 210 through the gap g. The charged air particles may deteriorate performance of the electronic device 101. For example, the charged air particles may cause deterioration of communication performance of the electronic device 101 by interfering with a wireless signal transmitted or received through the electronic device 101. For example, the charged air particles may cause malfunction of the electronic device 101 by interfering with an electrical signal between electronic components of the electronic device 101.

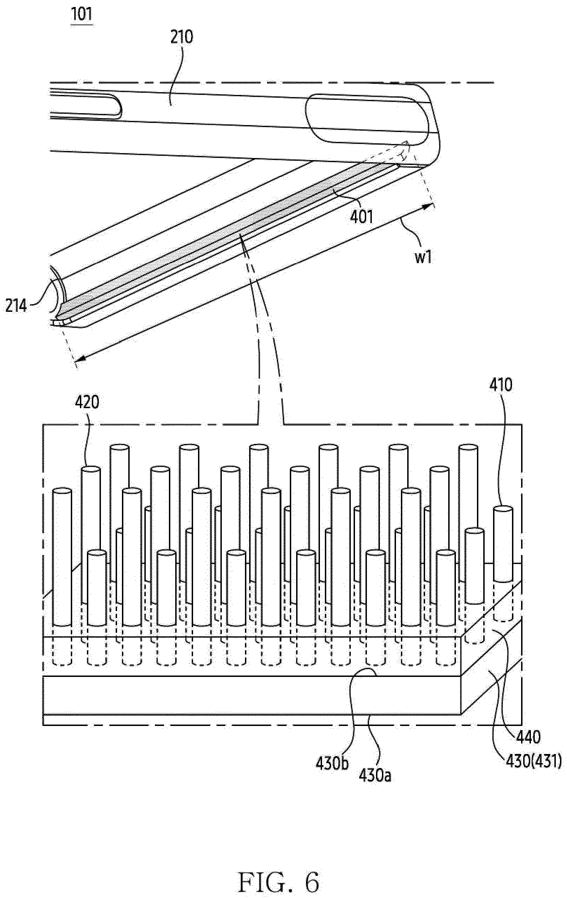

Referring to FIG. 5C, the electronic device 101 may further include a conductive tape 402. For example, the conductive tape 402 may be disposed between the first housing 210 and the display 230 for electrostatic discharge (ESD) of the first housing 210 or the display 230. The conductive tape 402 may be spaced apart from the display 230 so as not to interfere with the movement of the display 230. For example, the conductive tape 402 may be disposed at a position where the second area 230b is rolled into the first housing 210, but is not limited thereto. For example, the electrostatic discharge of the electronic device 101 may be performed by the foreign matter prevention part 401 and the conductive tape 402. For example, the static electricity inside of the first housing 210 may be discharged through a first path comprising the conductive tape 402 coupled to the first housing 210 and a second path comprising the foreign matter prevention part 401. For example, a width of the conductive tape 402 may be substantially the same as or similar to a width (e.g., a width w1 of FIG. 6) of the foreign matter prevention part 401 so that the static electricity may be discharged through the conductive tape 402, for example, along the entire width of the foreign matter prevention part 401.

According to an example, advantageously, the foreign matter prevention part 401 may include a structure capable of discharging the static electricity due to the friction. Advantageously, he foreign matter prevention part 401 may reduce the inflow of the foreign matter into the gap g by contacting the second area 230b and reduce performance deterioration of the electronic device 101 by discharging the static electricity. The foreign matter prevention part 401 prevents or reduces static electricity induction into the electronic device 101 from the outside of the electronic device101. Hereinafter, a structure for the static electricity discharge of the foreign matter prevention part 401 will be described.

FIG. 6 illustrates an electronic device in which a display is omitted.

Referring to FIG. 6, a foreign matter prevention part 401 may be coupled to the inside of a first housing 210. For example, the foreign matter prevention part 401 may have a width along which a foreign matter inflow into the first housing 210 is reduced. For example, a width w1 of the foreign matter prevention part 401 may be greater than or equal to a width (e.g., a width w2 of FIG. 3A) of a second area 230b (e.g., the second area 230b of FIG. 3A) that may be bent or rolled into the first housing 210. However, it is not limited thereto.

For example, the foreign matter prevention part 401 may be disposed inside the first housing 210 that accommodates at least a portion of the second area (e.g., the second area 230b of FIG. 5A). According to an example, the foreign matter prevention part 401 may include a conductive portion 410 and a non-conductive portion 420.

For example, the non-conductive portion 420 may be a portion that contacts at least a portion of one surface (e.g., a surface 231 of FIG. 5A) in the second area 230b. The non-conductive portion 420 may contact at least a portion of the surface 231 in the second area 230b in order to reduce the inflow of the foreign matter through a gap (e.g., a gap g of FIG. 5A) between the second area 230b of the display 230 and the first housing 210.

For example, the non-conductive portion 420 may include non-conductive fibers in order to reduce damage to the display 230 due to contact of the foreign matter prevention part 401 with the second area 230b. For example, the non-conductive portion 420 may include polyethylene (PE) or nylon fibers, but is not limited thereto. Since the non-conductive portion 420 including the non-conductive fibers is not rigid and is soft, even though it contacts the second area 230b, damage to the second area 230b is reduced. For example, the foreign matter prevention part 401 may include a base 440 for supporting the non-conductive fibers. The base 440 may be more rigid than the non-conductive fibers so as to support the soft non-conductive portion 420.

According to an example, the conductive portion 410 may be configured to discharge static electricity generated by friction between the second area 230b and the foreign matter prevention part 401. For example, the conductive portion 410 may be electrically connected to the first housing 210 so that the static electricity may be discharged through the first housing 210. For example, the conductive portion 410 may include a conductive material (e.g., metal). For example, the conductive portion 410 may include conductive fibers. However, it is not limited thereto. Static electricity having electrical conductivity may flow into the conductive portion 410 having electrical conductivity, based on electrical attraction. Because the conductive portion 410 is electrically connected to the first housing 210, the static electricity may be discharged, by flowing into the housing 210 through the conductive portion 410. For example, the conductive portion 410 may be formed by coating a protrusion including a non-conductive material with the conductive material. The static electricity may be induced into the conductive portion 410 including the conductive material. The static electricity induced into the conductive portion 410 may be discharged through the first housing 210 that is electrically connected to the conductive portion 410. For example, in order to discharge the static electricity, the conductive portion 410 may be electrically connected to a ground of the first housing 210. For example, the ground of the first housing 210 may be electrically connected to a ground layer of a main PCB (e.g., a PCB 324 of FIG. 3A) or a ground layer of a sub-PCB (e.g., a sub-PCB 327 of FIG. 3A). According to an example, the static electricity generated by the friction between the second area 230b and the foreign matter prevention part 401 may be discharged to the ground of the first housing 210, the ground layer of the main PCB 324, or the ground layer of the sub-PCB 324 via the foreign matter prevention part 401 including the conductive portion 410.

According to an example, the foreign matter prevention part 401 may further include at least one adhesive layer 430. For example, the at least one adhesive layer 430 may couple the non-conductive portion 420 and the conductive portion 410 to the first housing 210, by being disposed between the first housing 210 and the base 440 of the foreign matter prevention part 401. For example, one surface 430a of the at least one adhesive layer 430 may be coupled to an inner surface of the first housing 210 facing the display 230. The inner surface of the first housing 210 may be a surface of the first housing 210 forming a recess 214. Another surface 430b of the at least one adhesive layer 430, which is opposite to the surface 430a, may contact the base 440. The base 440 supporting the non-conductive portion 420 may be coupled to the surface of the first housing 210 through the at least one adhesive layer 430. For example, a length from the at least one adhesive layer 430 to a distal end of the non-conductive portion 420 may be more than or equal to the width of the gap g so that the foreign matter prevention part 401 may reduce the inflow of the foreign matter through the gap g between the second area 230b and the first housing 210.

According to an example, the conductive portion 410 may extend from the other surface 430b of the at least one adhesive layer 430 toward the display 230. For example, the conductive portion 410 and the non-conductive portion 420 may be provided integrally by providing the protrusions including the non-conductive material coated with the conductive material. These protrusions penetrate the base 440, from the at least one adhesive layer 430. In other cases, the conductive portion 410 and the non-conductive portion 420 may be provided separately, i.e. not integrally, such that the non-conductive portion 420 includes the non-conductive fibers and the conductive portion 410 includes the conductive fibers. In such cases, the conductive fibers may be disposed between the non-conductive fibers. The conductive fibers and the non-conductive fibers may be repeatedly disposed along the recess 214. For example, when viewing the foreign matter prevention part 401 in a direction from the non-conductive portion 420 toward the base 440, the conductive portion 410 may overlap the non-conductive portion 420. However, it is not limited thereto.

For example, referring to an enlarged view of the foreign matter prevention part 401 illustrated in FIG. 6, the foreign matter prevention part 401 may include a plurality of rows in which the conductive portion 410 and the non-conductive portion 420 are disposed along the recess 214. The foreign matter prevention part 401 illustrated in FIG. 6 is shown with alternating rows of the conductive portion 410 and the non-conductive portion 420, but is not limited thereto. For example, different rows may include different arrangements of the conductive portion 410 and the non-conductive portion 420. For example, the conductive portion 410 and the non-conductive portion 420 may be formed in zigzag rows with a row of the conductive portion 410 adjacent a row of the non-conductive portion 420. For another example, a lattice structure may be formed in which only the conductive portion 410 is disposed in an area of the foreign matter prevention part 401, and only the non-conductive portion 420 is disposed in another area of the foreign matter prevention part 401. For yet another example, density of the conductive portion 410 and the non-conductive portion 420 included in the area of the foreign matter prevention part 401 may be different from density of the conductive portion 410 and the non-conductive portion 420 included in the other area of the foreign matter prevention part 401. In addition to this, various structures may be possible. The density may refer to the ratio of conductive to non-conductive fibers.

According to an example, the at least one adhesive layer 430 may include a conductive adhesive layer 431. For example, the conductive adhesive layer 431 may include the conductive material (e.g., silver, copper, aluminum, or iron) to be electrically connected to the conductive portion 410 and the first housing 210. According to an example, the conductive portion 410 may be electrically connected to the first housing 210 through the conductive adhesive layer 431. For example, the conductive adhesive layer 431 may electrically connect the conductive portion 410 to the first housing 210, by being connected to each of the first housing 210 and the conductive portion 410.

According to an example, static electricity generated by friction between the second area 230b and the non-conductive portion 420 of the foreign matter prevention part 401 may be induced to the conductive portion 410 disposed in the non-conductive portion 420. The static electricity may be induced into the conductive portion 410 by an attractive force between a charge forming the static electricity and the conductive portion 410 including the conductive material. The static electricity induced to the conductive portion 410 may be induced to the first housing 210 through the conductive adhesive layer 431 electrically connected to the conductive portion 410. Since the first housing 210 may be electrically connected to the ground of the electronic device 101, the static electricity may be discharged through the first housing 210. For example, a discharge path of the static electricity may be formed along the conductive portion 410, the conductive adhesive layer 431, and the first housing 210. As the static electricity is discharged, performance deterioration of the electronic device 101 due to the static electricity may be reduced.

According to an example, the conductive portion 410 may be spaced apart from the second area 230b. For example, a length from the conductive adhesive layer 431 to a distal end of the conductive portion 410 may be smaller than the gap g between the second area 230b and the first housing 210. For example, a length of the non-conductive portion 420 may be longer than a length of the conductive portion 410. Since the conductive portion 410 includes a conductive material, it may be at least partially rigid. In case that the rigid conductive portion 410 contacts the second area 230b, the display 230 may be damaged by friction between the second area 230b and the conductive portion 410 as a position of the second area 230b is changed, i.e., the display 230 is scratched. In order to reduce damage to the display 230 due to contact between the second area 230b and the conductive portion 410, the conductive portion 410 may be spaced apart from the second area 230b.

According to an example, the static electricity generated by the friction between the second area 230b and the foreign matter prevention part 401 or the inflow the charged air particles may be discharged through the conductive portion 410 of the foreign matter prevention part 401. The charge forming the static electricity may move through the discharge path including the conductive portion 410, the conductive adhesive layer 431, and the first housing 210. The foreign matter prevention part 401 may reduce the performance deterioration of the electronic device 101 due to static electricity and the inflow of the foreign matter into the gap g between the second area 230b and the first housing 210 through this electrostatic discharge (ESD).

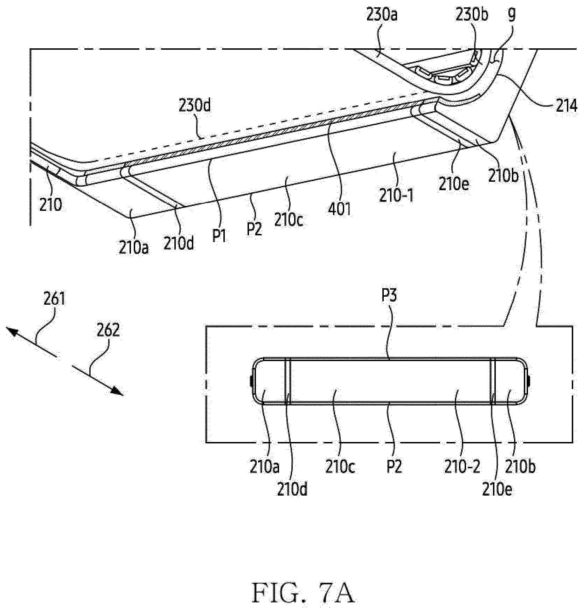

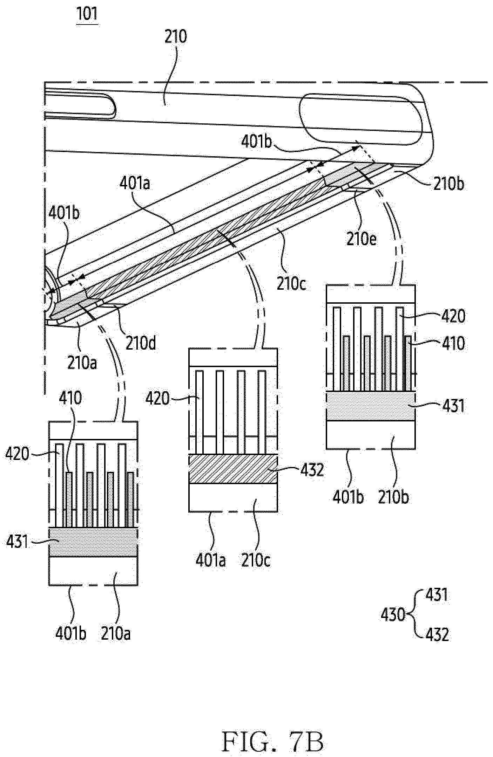

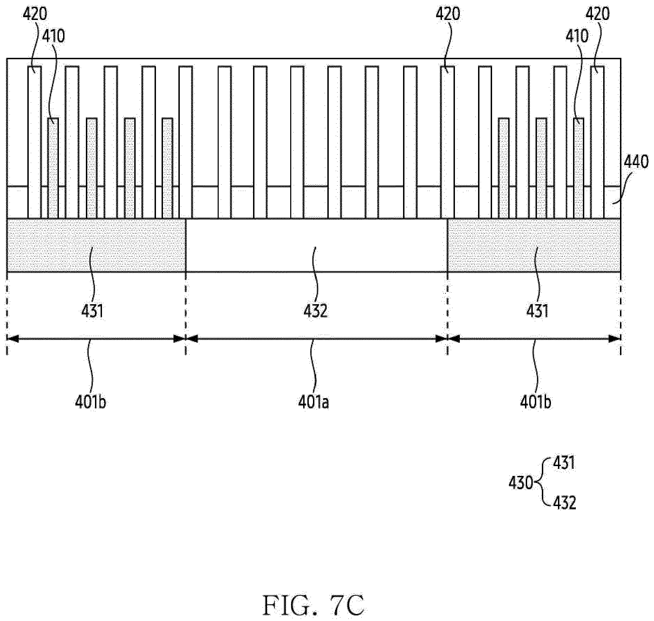

FIG. 7A is a partial cross-sectional view of the electronic device of FIG. 2A cut along A-A'. FIG. 7B illustrates the electronic device of FIG. 7A in which a display is omitted. FIG. 7C illustrates a foreign matter prevention part.

Referring to FIG. 7A, a foreign matter prevention part 401 may be disposed in a recess 214 of a first housing 210. For example, the foreign matter prevention part 401 may be parallel to a first periphery P1 of an electronic device 101. For example, when the electronic device 101 is in a first state, the first periphery P1 may overlap a boundary 230d between a first area 230a and a second area 230b, but is not limited thereto. The foreign matter prevention part 401 disposed parallel to the first periphery P1 may reduce the inflow of foreign matter into the electronic device 101, by being disposed between the first housing 210 and a display 230. A shape of the foreign matter prevention part 401 may correspond to a shape of the second area 230b bent inside the first housing 210. For example, in the first state, the second area 230b may be disposed in the recess 214 in a bent shape. The shape of the foreign matter prevention part 401 may correspond to the bent shape of the second area 230b. Since the shape of the foreign matter prevention part 401 corresponds to the shape of the second area 230b, the inflow of the foreign matter into the gap g may be reduced, and even if the second area 230b moves in a state of contacting with the foreign matter prevention part 401, the second area 230b may not be damaged.

According to an example, a portion of the first housing 210 may be used as a portion of an antenna (e.g., a radiator antenna) for communication with an external electronic device. When the portion of the first housing 210 operates as an antenna for transmitting or receiving a wireless signal, and when static electricity flows along the first housing 210, performance of the antenna may be deteriorated. For example, when the wireless signal is transmitted or received through the portion of the first housing 210, the wireless signal may be distorted as it interacts electromagnetically with the static electricity. For example, when the static electricity flows through the portion of the first housing 210 operating as the antenna, a gain of an antenna may be reduced.

Referring to FIG. 7A, the first housing 210 may include a structure for at least partially surrounding the second area 230b. For example, the first housing 210 may include a first surface 210-1, a second surface 210-2, and a third surface (e.g., a third surface 210-3 of FIG. 5A) that at least partially surrounds the second area 230b.

For example, the first housing 210 may include the recess 214 for accommodating the second area 230b. When the electronic device 101 is in the first state, the second area 230b may be accommodated in the recess 214 of the first housing 210. As the electronic device 101 changes from the first state to a second state, the second area 230b may be drawn out from inside of the recess 214 and may be exposed to the outside. The second area 230b may be at least partially covered by the first surface 210-1 and the second surface 210-2. For example, the foreign matter prevention part 401 may be disposed at a position where the second area 230b is rolled into the recess 214.

According to an example, the first housing 210 may include a plurality of conductive portions 210a, 210b, and 210c that are separated from each other. For example, the first housing 210 may include a plurality of non-conductive portions 210d and 210e for electrically separating the plurality of conductive portions 210a, 210b, and 210c. The plurality of non-conductive portions 210d and 210e may be disposed along the first surface 210-1 and the second surface 210-2. For example, the plurality of non-conductive portions 210d and 210e may extend from the first periphery P1 of the first surface 210-1 facing a first direction 261, past a second periphery P2 where the first surface 210-1 and the second surface 210-2 contact each other, to a third periphery P3 where the second surface 210-2 and the third surface (e.g., the third surface 210-3 of FIG. 5A) contact each other. For example, the plurality of non-conductive portions 210d and 210e may include a first non-conductive portion 210d and a second non-conductive portion 210e spaced apart from each other.

For example, the plurality of conductive portions 210a, 210b, and 210c may include a first conductive portion 210a, a second conductive portion 210b, and a third conductive portion 210c separated by the first non-conductive portion 210d and the second non-conductive portion 210e, respectively. The first conductive portion 210a, the second conductive portion 210b, and the third conductive portion 210c may be formed along the first surface 210-1 and the second surface 210-2. For example, the third conductive portion 210c may be located between the first conductive portion 210a and the second conductive portion 210b. For example, one side of the third conductive portion 210c may contact the first non-conductive portion 210d, and another side of the third conductive portion 210c may contact the second non-conductive portion 210e. For example, the first conductive portion 210a may contact the first non-conductive portion 210d. For example, the second conductive portion 210b may contact the second non-conductive portion 210e.

The electronic device 101 according to an example may further include a wireless communication circuit (e.g., a wireless communication module 192 of FIG. 1). For example, the wireless communication circuit 192 may feed the portion of the first housing 210 through a PCB (e.g., a PCB 324 of FIG. 3A) or a sub-PCB (e.g., a sub-PCB 327 of FIG. 3A). For example, the wireless communication circuit 192 may be electrically connected to the third conductive portion 210c through the PCB 324 and the sub-PCB 327, but is not limited thereto. For example, the wireless communication circuit 192 may be electrically connected to the third conductive portion 210c through the PCB 324. The wireless communication circuit 192 may be configured to feed the third conductive portion 210c. The third conductive portion 210c may be configured to transmit a wireless signal on a designated frequency band based on receiving a feeding signal from the wireless communication circuit 192. For example, the third conductive portion 210c receives the wireless signal from the external electronic device, and the received wireless signal may be provided to the wireless communication circuit 192 through the PCB 324 and the sub-PCB 327. For example, the frequency band of the wireless signal transmitted or received through the third conductive portion 210c may be determined based on a length of the third conductive portion 210c.

As described above, the foreign matter prevention part 401 may include a conductive portion 410 and a conductive adhesive layer 431 for discharging the static electricity. The conductive portion 410 may be configured to discharge the static electricity by being electrically connected to the first housing 210 through the conductive adhesive layer 431. In case that the conductive portion 410 is electrically connected to the third conductive portion 210c operating as the antenna, wireless communication performance of the electronic device 101 may be deteriorated.

Referring to FIG. 7B, in order to reduce the deterioration of the wireless communication performance of the electronic device 101, the conductive portion 410 and the conductive adhesive layer 431 may be electrically separated from the portion (e.g., the third conductive portion 210c of FIG. 7A) of the first housing 210 operating as the antenna.

For example, the foreign matter prevention part 401 may include a first portion 401a and a second portion 401b. The first portion 401a may be a portion of the foreign matter prevention part 401 corresponding to the portion (e.g., the third conductive portion 210c of FIG. 7A) of the first housing 210 operating as the antenna. For example, the first portion 401a may be a portion of the foreign matter prevention part 401 that overlaps the portion of the first housing 210. For example, the second portion 401b may be a portion of the foreign matter prevention part 401 corresponding to the other portion (e.g., the first conductive portion 210a or the second conductive portion 210b of FIG. 7A) of the first housing 210 that is distinct from the portion of the first housing 210. The other portion of the first housing 210 may indicate a portion of the first housing 210 (e.g., the third conductive part 210c) electrically disconnected from the portion (e.g., the third conductive portion 210c) of the first housing 210 operating as the antenna (e.g., the first conductive part 210a) or the second conductive part 210b).

In order to reduce the deterioration of the wireless communication performance of the electronic device 101, the conductive portion 410 may not be disposed in the first portion 401a, but may be disposed only in the second portion 401b. For example, the conductive portion 410 may be disposed in the second portion 401b of the first portion 401a and the second portion 401b. For example, a non-conductive portion 420 may be disposed in the first portion 401a and the second portion 401b, and the conductive portion 410 may be disposed only in the second portion 401b.

For example, the foreign matter prevention part 401 may contact the first conductive portion 210a, the second conductive portion 210b, and the third conductive portion 210c. In case that the third conductive portion 210c operates as the antenna by being fed from the wireless communication circuit (e.g., the wireless communication module 192 of FIG. 1), the conductive portion 410 of the foreign matter prevention part 401 may be electrically connected to the first conductive portion 210a and the second conductive portion 210b among the first conductive portion 210a, the second conductive portion 210b, and the third conductive portion 210c, and may be electrically separated from the third conductive portion 210c. Even if the foreign matter prevention part 401 contacts the third conductive portion 210c, the conductive portion 410 may not be electrically connected to the third conductive portion 210c. For example, the first portion 401a may be a portion of the foreign matter prevention part 401 corresponding to the third conductive portion 210c operating as the antenna. For example, the second portion 401b may be a portion of the foreign matter prevention part 401 corresponding to the first conductive portion 210a and the second conductive portion 210b, which are distinct from the third conductive portion 210c. In order to reduce the deterioration of the wireless communication performance of the electronic device 101, the conductive portion 410 may not be disposed in the first portion 401a, but may be disposed only in the second portion 401b. For example, the conductive portion 410 may be disposed in the second portion 401b of the first portion 401a and the second portion 401b. For example, the non-conductive portion 420 may be disposed in the first portion 401a and the second portion 401b, and the conductive portion 410 may be disposed only in the second portion 401b.

For example, the first portion 401a may contact the third conductive portion 210c. The second portion 401b may extend along the first conductive portion 210a or the second conductive portion 210b from a boundary of the third conductive portion 210c in contact with the first non-conductive portion 210d or the second non-conductive portion 210e.

The foreign matter prevention part 401 illustrated in FIG. 7B is only an example of a structure for explaining that a conductive material is not included in the foreign matter prevention part 401 overlapping the portion (e.g., the third conductive portion 210c of FIG. 7A) of the first housing 210 operating as the antenna, and the foreign matter prevention part 401 is not limited to a structure illustrated in FIG. 7B. The foreign matter prevention part 401 may be various.

In FIG. 7B, the first portion 401a is illustrated as being disposed along the entire portion (e.g., the third conductive portion 210c) of the first housing 210 operating as the antenna, but is not limited thereto. For example, the first portion 401a may contact at least a portion of the first housing 210. For another example, the first portion 401a may contact a portion of the first conductive portion 210a or a portion of the second conductive portion 210b.

In FIG. 7B, the first portion 401a is illustrated as being disposed along the boundary of the third conductive portion 210c, but is not limited thereto. For example, the first portion 401a may extend from a point corresponding to the first non-conductive portion 210d in contact with the third conductive portion 210c to a point corresponding to the second non-conductive portion 210e.

Referring to FIG. 7C, the foreign matter prevention part 401 may not include the conductive portion 410 and at least one conductive adhesive layer 431 in the first portion 401a corresponding to the portion of the first housing 210 operating as the antenna. For example, the non-conductive portion 420 may be coupled to the first housing 210 by a non-conductive adhesive layer 432. The non-conductive portion 420 may be disposed in both the first portion 401a and the second portion 401b in order to reduce the inflow of the foreign matter through the gap g between the second area 230b and the first housing 210, the conductive portion 410 and the at least one conductive adhesive layer 431 may be disposed only in the second portion 401b of the first portion 401a and the second portion 401b.

A structure of the second portion 401b illustrated in FIG. 7C is merely exemplary and is not limited to a structure illustrated in FIG. 7C. For example, the structure of the second portion 401b illustrated in FIG. 7C includes a structure in which the conductive portion 410 and the non-conductive portion 420 are alternately disposed, but is not limited thereto. For example, a disposition structure of the conductive portion 410 and the non-conductive portion 420 forming a row may be different from a disposition structure of the conductive portion 410 and the non-conductive portion 420 forming another row. For example, the disposition structure of the conductive portion 410 and the non-conductive portion 420 disposed in the row may be formed in a zigzag form with a disposition structure of the conductive portion 410 and the non-conductive portion 420 disposed in the other row adjacent to the row. For another example, a lattice structure may be formed in which only the conductive portion 410 is disposed in an area of the foreign matter prevention part 401, and only the non-conductive portion 420 is disposed in another area of the foreign matter prevention part 401. For still another example, density of the conductive portion 410 and the non-conductive portion 420 included in the area of the foreign matter prevention part 401 may be different from density of the conductive portion 410 and the non-conductive portion 420 included in the other area of the foreign matter prevention part 401. In addition to this, various structures may be possible.

For example, in case that the third conductive portion 210c operates as the antenna, the conductive adhesive layer 431 may be coupled to the first conductive portion 210a and the second conductive portion 210b except the third conductive portion 210c. The non-conductive adhesive layer 432 may be coupled to the third conductive portion 210c. The base 440 may be coupled to the first housing 210 by the non-conductive adhesive layer 432 and the conductive adhesive layer 431. The conductive portion 410 may be connected to the conductive adhesive layer 431 coupled to the first conductive portion 210a and the second conductive portion 210b. The non-conductive portion 420 may be disposed along the entire area of the base 440.

Since the conductive portion 410 is connected to the conductive adhesive layer 431 coupled to the first conductive portion 210a and the second conductive portion 210b, the conductive portion 410 may be disposed in a position (e.g., the second portion 401b) overlapping the first conductive portion 210a and the second conductive portion 210b, and may not be disposed in a position (e.g., the first portion 401a) overlapping the third conductive portion 210c. For example, the non-conductive adhesive layer 432 may be coupled to the third conductive portion 210c. Since the conductive portion 410 is not connected to the non-conductive adhesive layer 432 coupled to the third conductive portion 210c, only the non-conductive portion 420 may be disposed in a position (e.g., the second portion 401b) corresponding to the third conductive portion 210c. For example, when viewing the foreign matter prevention part 401 from above, a position (e.g., the second portion 401b) where the conductive portion 410 and the conductive adhesive layer 431 are disposed may overlap the first conductive portion 210a and the second conductive portion 210b, and may be spaced apart from the third conductive portion 210c. For example, when viewing the foreign matter prevention part 401 from above, the conductive portion 410 including the conductive material and the conductive adhesive layer 431 may not be disposed in a position (e.g., the first portion 401a) overlapping the third conductive portion 210c. According to an example, the third conductive portion 210c operating as the antenna, may be electrically separated from the conductive portion 410. By reducing the electromagnetic interaction between the conductive portion 410 and the wireless signal transmitted or received through the third conductive portion 210c, the deterioration of the wireless communication performance of the electronic device 101 may be reduced.

According to an example, the first conductive portion 210a and the second conductive portion 210b may be electrically connected to a ground of the electronic device 101. Referring again to FIG. 3A, the sub-PCB 327 may be disposed on a first cover 311 of the first housing 210. For example, the sub-PCB may be disposed in a +z direction with respect to the first cover 311. The first conductive portion 210a, the second conductive portion 210b, and the third conductive portion 210c may be electrically connected to the sub-PCB 327. For example, at least a portion of the first cover 311 or at least a portion of the frame 313 may provide the ground of the electronic device 101. The sub-PCB 327 may be electrically connected to the ground. For example, a ground layer of the sub-PCB 327 may be electrically connected to the ground of the electronic device 101. The first conductive portion 210a and the second conductive portion 210b may be electrically connected to the ground of the electronic device 101 through the sub-PCB 327. Since the first conductive portion 210a and the second conductive portion 210b are electrically connected to the ground of the electronic device 101, they may be grounded.

According to an example, the conductive portion 410 may be configured to discharge the static electricity by being electrically connected to the first conductive portion 210a and the second conductive portion 210b. For example, static electricity generated by the friction between the second area 230b and the foreign matter prevention part 401 is provided to the first conductive portion 210a and the second conductive portion 210b through the conductive portion 410 and the conductive adhesive layer, and may be discharged through the ground of the electronic device 101. For example, as a charge charged by the friction flows to the ground, the static electricity may be discharged.

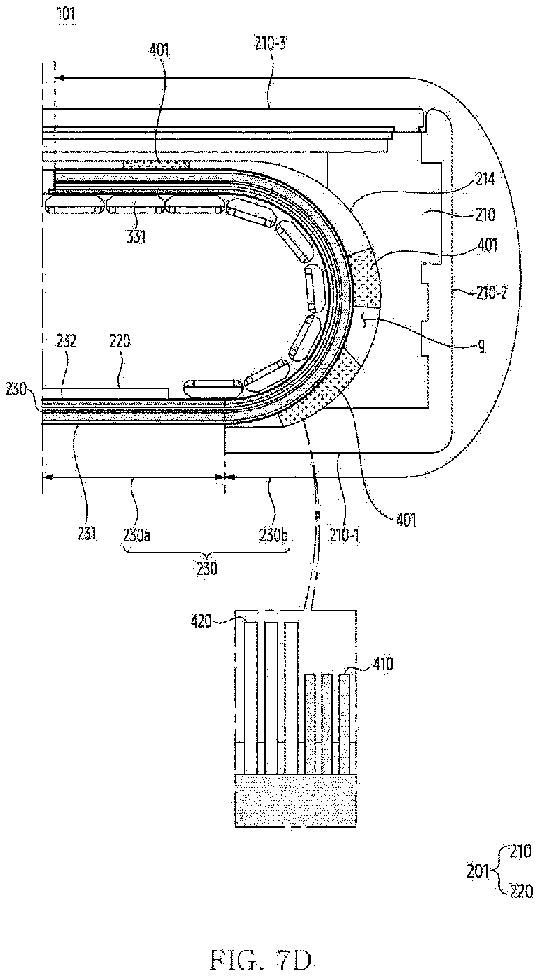

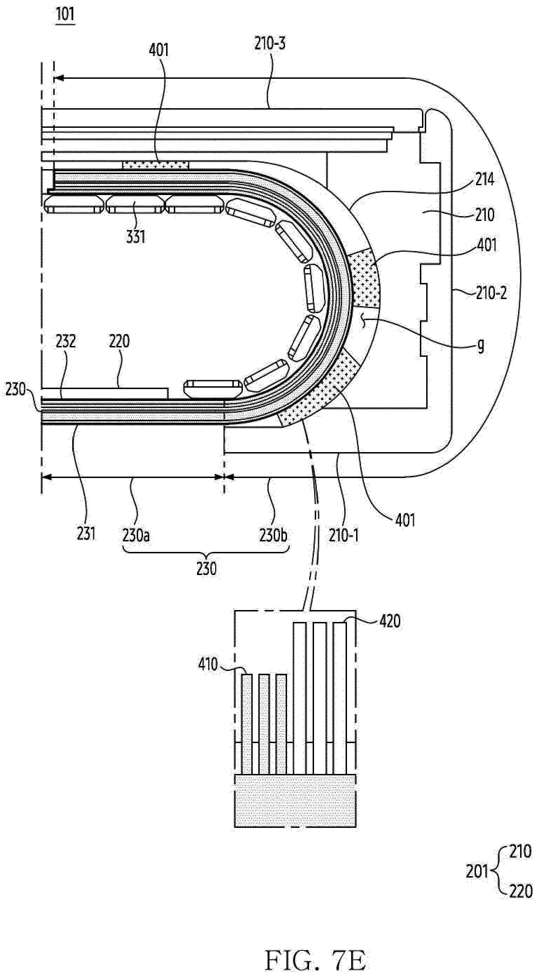

FIGS. 7D and 7E illustrate a portion of an electronic device in a first state.

FIG. 7D indicates another example of a foreign matter prevention part 401. As described above, conductive fibers of a conductive portion 410 may penetrate a base 440 and may be disposed in non-conductive fibers of a non-conductive portion 420, but are not limited thereto. For example, the conductive portion 410 and the non-conductive portion 420 may not be included in the same row. For example, only the conductive portion 410 may be disposed in a partial area of the foreign matter prevention part 401, and only the non-conductive portion 420 may be disposed in another area of the foreign matter prevention part 401.

For example, referring to FIG. 7D, the non-conductive portion 420 may be disposed outside the conductive portion 410. For example, the outside may indicate a direction in which the second area 230b is drawn out from the inside of a first housing 210 when an electronic device 101 is transformed from the first state to a second state. For example, inside opposite to the outside may indicate a direction in which the second area 230b is inserted into the first housing 210 when the electronic device 101 is transformed from the second state to the first state. For example, the non-conductive fibers forming the non-conductive portion 420 may be disposed outside the foreign matter prevention part 401 with respect to the conductive fibers forming the conductive portion 410. For example, the conductive fibers forming the conductive portion 410 may be disposed inside the foreign matter prevention part 401 with respect to the non-conductive fibers forming the non-conductive portion 420. For example, the non-conductive portion 420 may be disposed on the outside of the foreign matter prevention part 401 to reduce the inflow of foreign matter through a gap g between a display 230 and the first housing 210. For example, the conductive portion 410 may be configured to discharge static electricity generated by friction between the foreign matter prevention part 401 and the display 230, by being disposed inside the non-conductive portion 420. A height (e.g., a second height h2) of the non-conductive portion 420 contacting the second area 230b may be greater than a height (e.g., a first height h1) of the conductive portion 410 spaced apart from the second area 230b. As illustrated in FIG. 7D, even if the conductive portion 410 is disposed outside the non-conductive portion 420, since the conductive portion 410 is adjacent to the non-conductive portion 420, the static electricity may be guided to the first housing 210. The static electricity may be discharged to the ground of the electronic device 101 through the first housing 210.

For example, referring to FIG. 7E, the conductive portion 410 may be disposed the outside the non-conductive portion 420.

For example, the non-conductive fibers forming the non-conductive portion 420 may be disposed the inside the foreign matter prevention part 401 with respect to the conductive fibers forming the conductive portion 410. For example, the conductive fibers forming the conductive portion 410 may be disposed the outside the foreign matter prevention part 401 with respect to the non-conductive fibers forming the non-conductive portion 420. For example, the conductive portion 410 may be disposed the outside the foreign matter prevention part 401 in order to discharge charged air particles that flowed in through the gap g between the display 230 and the first housing 210. For example, the non-conductive portion 420 may reduce the inflow of the foreign matter through the gap g by being disposed inside the conductive portion 420.

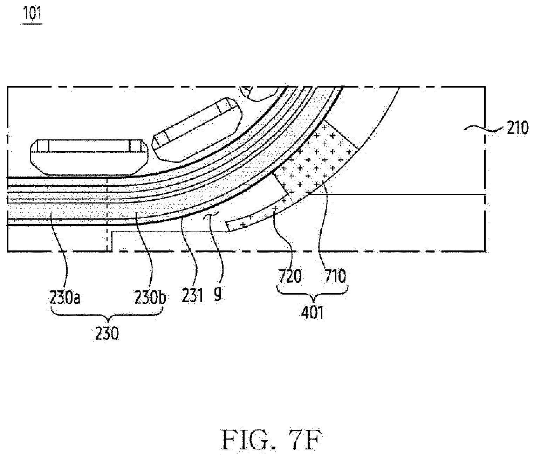

FIG. 7F is an enlarged view of a portion of an electronic device.

In case of a foreign matter prevention part 401 described above, it is illustrated as including a conductive portion 410 protruded toward a display 230 for discharging static electricity, but is not limited thereto. Referring to FIG. 7F, the foreign matter prevention part 401 may include a first area 710 in contact with a surface 231 in a second area 230b and a second area 720 that is spaced apart from the surface 231 and includes a conductive material.

For example, the first area 710 may reduce the inflow of foreign matter through a gap g by contacting the surface 231 in the second area 230b. For example, the first area 710 may include a non-conductive portion (e.g., a non-conductive portion 420 of FIG. 6) formed of a plurality of non-conductive fibers.

For example, the second area 720 may be spaced apart from the surface 231 of the display 230. For example, the second area 720 may include a conductive tape, but is not limited thereto. The second area 720 may be disposed outside the first area 710, as illustrated in FIG. 7F, but is not limited thereto. For example, the second area 720 may be disposed inside the first area 710. For example, the second area 720 may at least partially overlap the first area 710. For example, the outside may indicate a direction in which the second area 230b is drawn out from the inside of the first housing 210 when an electronic device 101 is transformed from the first state to the second state. For example, the inside opposite to the outside may indicate a direction in which the second area 230b is inserted into the inside of the first housing 210 when the electronic device 101 is transformed from the second state to the first state.

For example, the first area 710 may reduce the inflow of the foreign matter into the first housing 210, and the second area 720 may discharge the static electricity. For example, the first area 710 may reduce the inflow of the foreign matter through the gap g by contacting the surface 231. For example, the second area 720 may discharge static electricity generated by friction between the foreign matter prevention part 401.

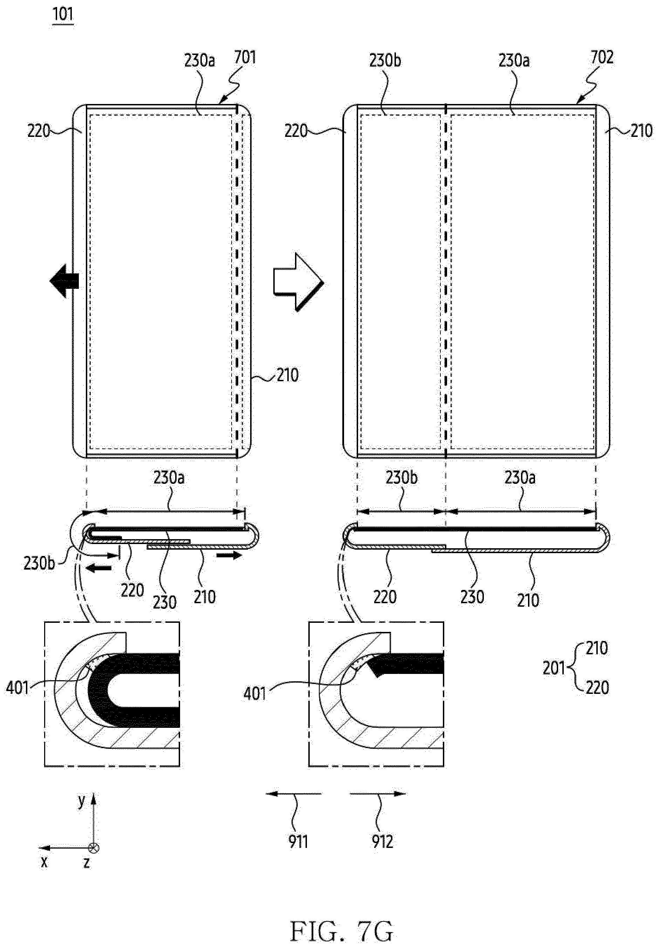

FIG. 7G illustrates an electronic device.

In an electronic device 101 illustrated in FIGS. 2A to 7F, a movement direction of a second housing 220 with respect to a first housing 210 is illustrated in a direction parallel to a y-axis (e.g., a y-axis of FIG. 2A), but a structure of the electronic device 101 is not limited thereto. Referring to FIG. 7G, the electronic device 101 may include a housing 201 that is movably coupled in a direction parallel to an x-axis. The electronic device 101 illustrated in FIG. 7G may be substantially the same as the electronic device 101 described above, except for the movement direction of the second housing 220 with respect to the first housing 210 described with reference to FIG. 7G. The same reference numeral are assigned to the same component as the above-described component, and an overlapping description may be omitted.

Referring to FIG. 7G, the electronic device 101 may include the housing 201 including the first housing 210 and the second housing 220. For example, the second housing 220 may be movable in a first direction 911 and a second direction 912 parallel to the x-axis.

For example, in a first state 701, at least a portion of the second housing 220 may be inserted into the first housing 210. In a first state, the second housing 220 may be movable with respect to the first housing 210 in the first direction 911 of the first direction 911 and the second direction 912. For example, in the first state, the second housing 220 may not be movable in the second direction 912.

For example, when the electronic device 101 changes from the first state 701 to the second state 702, the at least the portion of the second housing 220 may be moved from the first housing 210 in the first direction 911. In a second state, the second housing 220 may be movable with respect to the first housing 210 in the second direction 912 of the first direction 911 and the second direction 912. For example, in the second state, the second housing 220 may not be movable in the first direction 911.

For example, a display 230 may include a first area 230a and a second area 230b. At least a portion of the second area 230b may be bendable in the first housing 210 in the first state.

For example, the electronic device 101 may include a foreign matter prevention part 401. The foreign matter prevention part 401 may be disposed between a surface 231 in the second area 230b and the first housing 210. The foreign matter prevention part 401 may reduce the inflow of foreign matter through a gap between the second area 230b and the first housing 210. For example, the foreign matter prevention part 401 may be configured to discharge static electricity generated by friction between the second area 230b and the foreign matter prevention part 401. For example, the foreign matter prevention part 401 may include the above-described conductive portion (e.g., a conductive portion 410 of FIG. 6) and a non-conductive portion (e.g., a non-conductive portion 420 of FIG. 6). The foreign matter prevention part 401 illustrated in FIG. 7F may be substantially the same as the above-described foreign matter prevention part 401.

The above-described descriptions may be applied without being limited to the structure or shape of the electronic device 101. For example, the above-described electronic device 101 may describe the electronic device 101 as being rollable, but is not limited thereto. For example, the electronic device 101 may be various structures or shapes. For example, the electronic device 101 may include the housing 201 having a structure or a shape that is rotatably coupled to each other. Hereinafter, the electronic device 101 having the structure or the shape that is rotatably coupled to each other will be introduced with reference to drawings.

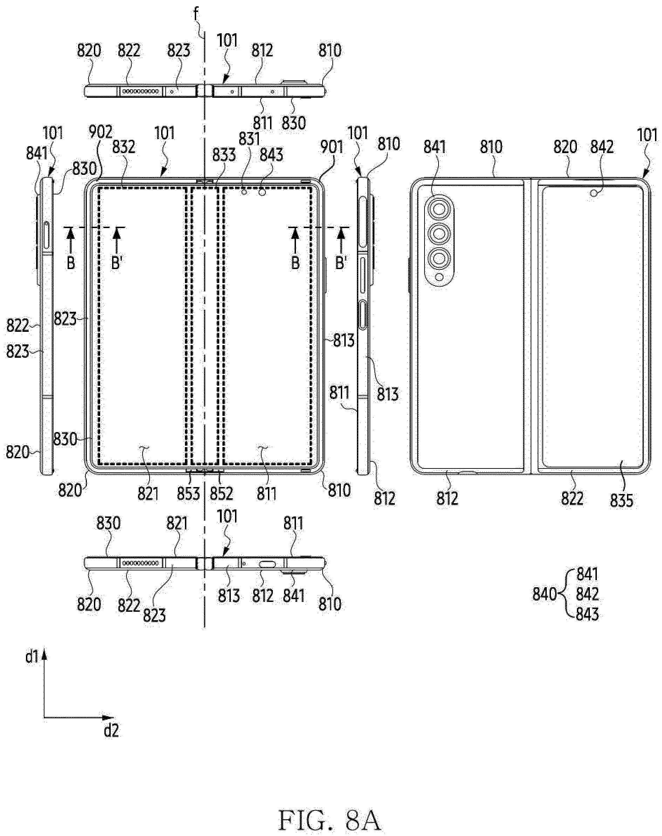

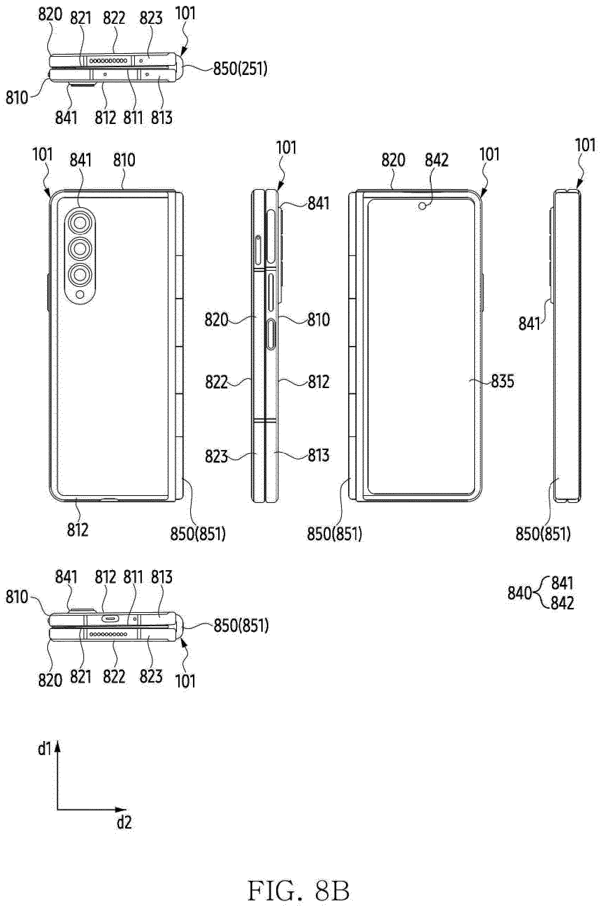

FIG. 8A illustrates an unfolding state of an electronic device. FIG. 8B illustrates a folding state of an electronic device.

Referring to FIGS. 8A and 8B, an electronic device 101 may include a first housing 810, a second housing 820, and a display 830, at least one camera 840, a hinge structure 850, or at least one electronic component 860.

For example, the first housing 810 may include a first surface 811, a second surface 812 opposite to the first surface 811, and a first side surface 813 surrounding at least a portion of the first surface 811 and the second surface 812. The first side surface 813 may connect a periphery of the first surface 811 to a periphery of the second surface 812.

For example, the second housing 820 may include a third surface 821, a fourth surface 822 opposite to the third surface 821, and a second side surface 823 surrounding at least a portion of the third surface 821 and the fourth surface 822. The second side surface 823 may connect a periphery of the third surface 821 to a periphery of the fourth surface 822. According to an example, the second housing 820 may be coupled to the first housing 810 to be rotatable with respect to the first housing 810.

According to an example, the display 830 may be disposed on the first surface 811 of the first housing 810 and the third surface 821 of the second housing 820 across the hinge structure 850. For example, the display 830 may include a first display area 831 disposed on the first surface 811 of the first housing, a second display area 832 disposed on the third surface 821 of the second housing, and a third display area 833 disposed between the first display area 831 and the second display area 832. According to an example, the display 830 may further include a sub-display panel 835 disposed on the fourth surface 822 of the second housing 820.

According to an example, the at least one camera 840 may be configured to obtain an image based on receiving light from an external subject of the electronic device 101. According to an example, the at least one camera 840 may include first cameras 841, a second camera 842, or a third camera 843. In an example, the first cameras 841 may be disposed in the first housing 810. For example, the first cameras 841 are disposed inside the first housing 810, and at least a portion of them may be visible through the second surface 812 of the first housing 810.

According to an example, the second camera 842 may be disposed in the second housing 820. For example, the second camera 842 may be disposed inside the second housing 820 and may be visible through the sub-display panel 835.

According to an example, the third camera 843 may be disposed in the first housing 810. For example, the third camera 843 may be disposed the inside the first housing 810, and at least a portion of them may be visible through the first surface 811 of the first housing 810. For example, the third camera 843 may be disposed the inside the first housing 810, and at least a portion of them may be visible through the first display area 831 of the display 830.

According to an example, the hinge structure 850 may rotatably connect the first housing 810 and the second housing 820. The hinge structure 850 may be disposed between the first housing 810 and the second housing 820 of the electronic device 101 so that the electronic device 101 may be bent or folded. For example, the hinge structure 850 may be disposed between a portion of the first side surface 813 and a portion of the second side surface 823 that face each other. The hinge structure 850 may change the electronic device 101 to an unfolding state in which the first surface 811 of the first housing 810 and the third surface 821 of the second housing 820 face the same direction or a folding state in which the first surface 811 and the third surface 821 face each other. When the electronic device 101 is in the folding state, the first housing 810 and the second housing 820 may superimpose or overlap each other by facing each other.

According to an example, when the electronic device 101 is in the folding state, a direction in which the first surface 811 faces and a direction in which the third surface 821 faces may be different from each other. For example, when the electronic device 101 is in the folding state, the direction in which the first surface 811 faces and the direction in which the third surface 821 faces may be opposite to each other. For another example, when the electronic device 101 is in the folding state, the direction in which the first surface 811 faces and the direction in which the third surface 821 faces may be inclined with respect to each other. In case that the direction in which the first surface 811 faces is inclined with respect to the direction in which the third surface 821 faces, the first housing 810 may be inclined with respect to the second housing 820.

According to an example, the electronic device 101 may be foldable with respect to a folding axis f. The folding axis f may mean a virtual line extending passing through a hinge cover 851 in a direction (e.g., a d1 of FIGS. 8A and 8B) parallel to a longitudinal direction of the electronic device 101, but is not limited thereto. For example, the folding axis f may be a virtual line extending in a direction (e.g., a d2 of FIGS. 8A and 8B) perpendicular to the longitudinal direction of the electronic device 101. In case that the folding axis f extends in a direction perpendicular to the longitudinal direction of the electronic device 101, the hinge structure 850 extends in a direction parallel to the folding axis f to connect the first housing 810 and the second housing 820. The first housing 810 and the second housing 820 may be rotatable by the hinge structure 850 extending in the direction perpendicular to the longitudinal direction of the electronic device 101.

According to an example, the hinge structure 850 may include the hinge cover 851, a first hinge plate 852, a second hinge plate 853, and a hinge module 854. The hinge cover 851 may surround the internal components of the hinge structure 850 and form an outer surface of the hinge structure 850. According to an example, when the electronic device 101 is in the folding state, at least a portion of the hinge cover 851 surrounding the hinge structure 850 may be exposed to outside of the electronic device 101 through between the first housing 810 and the second housing 820. According to another example, when the electronic device 101 is in the unfolding state, the hinge cover 851 may be covered by the first housing 810 and the second housing 820 and may not be exposed to the outside of the electronic device 101.

According to an example, the first hinge plate 852 and the second hinge plate 853 may rotatably connect the first housing 810 and the second housing 820, by being coupled to the first housing 810 and the second housing 820, respectively. For example, the first hinge plate 852 may be coupled to the first housing 810, and the second hinge plate 853 may be coupled to the second housing 820. The first housing 810 and the second housing 820 may be rotatable according to the rotation of the first hinge plate 852 and the second hinge plate 853.

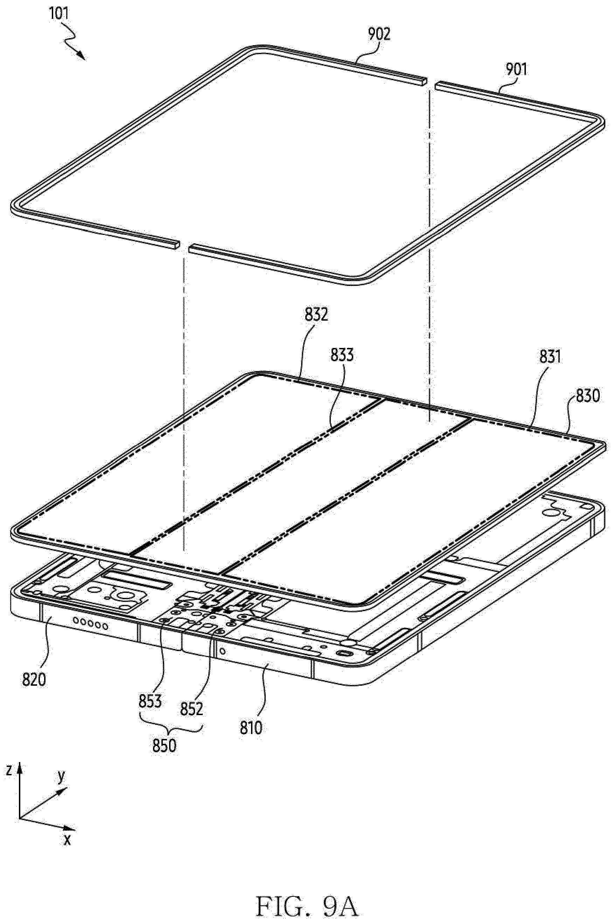

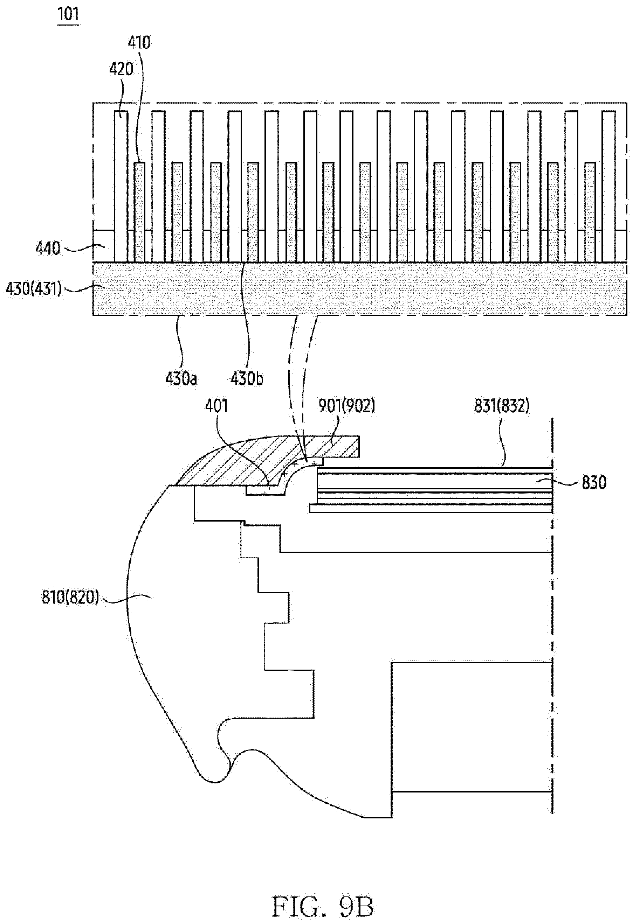

FIG. 9A is an exploded perspective view of an electronic device. FIG. 9B is a cross-sectional view of the electronic device of FIG. 8A cut along B-B'.

A foreign matter prevention part 401 illustrated in FIGS. 9A and 9B may be substantially the same as the above-described foreign matter prevention part 401. The same reference numerals are assigned to the same component as the above-described component, and an overlapping description may be omitted.

Referring to FIG. 9A, an exemplary electronic device 101 may further include protection members 901 and 902 that at least partially surround peripheries of a display 830. For example, the electronic device 101 may include a first protection member 901 that at least partially surrounds peripheries of a first display area 831, and a second protection member 902 that at least partially surrounds peripheries of a second display area 832. The first protection member 901 may be disposed on the first display area 831 and may protect the peripheries of the first display area 831. The second protection member 902 may be disposed on the second display area 832 and may protect the peripheries of the second display area 832. The peripheries of the first display area 831 surrounded by the first protection member 901 may not be exposed to the outside, and the peripheries of the second display area 832 surrounded by the second protection member 902 may not be exposed to the outside.

Since the third display area 833 may be deformed according to the rotation operation of the first housing 810 or the second housing 820, in case that the first protection member 901 and the second protection member 902 surround peripheries intersecting a folding axis f of the third display area 833, it may be difficult for the third display area 833 to be deformed by the rotation operation. According to an example, the first protection member 901 and the second protection member 902 may be spaced apart from each other so as not to interfere with the deformation of the third display area 833. For example, the first protection member 901 may be spaced apart from the second protection member 902 with the third display area 833 interposed therebetween.

Referring to FIG. 9B, the exemplary electronic device 101 may further include the foreign matter prevention part 401. For example, the foreign matter prevention part 401 may be disposed between the display 830 and the protection members 901 and 902. For example, the foreign matter prevention part 401 may be disposed between the first protection member 901 and the display 830 or between the second protection member 902 and the display 830. For example, the foreign matter prevention part 401 may be attached to the first protection member 901 or the second protection member 902.

For example, the foreign matter prevention part 401 may reduce the inflow of foreign matter through the gap g between the protection members 901 and 902 and the display 830. For example, the first protection member 901 may be spaced apart from the first display area 831, and the second protection member 902 may be spaced apart from the second display area 832. The foreign matter prevention part 401 may reduce the inflow of the foreign matter into inside of the electronic device 101 by being disposed in the gap g between the first protection member 901 and the first display area 831 or the gap g between the second protection member 902 and the second display area 832.

According to an example, the foreign matter prevention part 401 may include a conductive portion 410, a non-conductive portion 420, a base 440, and at least one adhesive layer 430.

For example, the non-conductive portion 420 may contact the display 830. The non-conductive portion 420 may contact a display area (e.g., the first display area 831 or the second display area 832) of the display 830 in order to reduce the inflow of the foreign matter through the gap g between the display 830 and the protection members 901 and 902. The non-conductive portion 420 may include non-conductive fibers in order to reduce damage to the display 830 due to contact with the display 830.

For example, the conductive portion 410 may be configured to discharge static electricity generated by friction between the display area (e.g., the first display area 831 or the second display area 832) of the display 830 and the protection members 901 and 902. For example, the conductive portion 410 may be electrically connected to the first housing 810 and the second housing 820 so that the static electricity may be discharged through the first housing 810 or the second housing 820. For example, the base 440 may support the conductive portion 410 and the non-conductive portion 420. For example, the at least one adhesive layer 430 may attach the foreign matter prevention part 401 to the protection members 901 and 902. The at least one adhesive layer 430 may include a conductive adhesive layer 431.

For example, the protection members 901 and 902 may include a conductive material (e.g., metal). The static electricity induced into the conductive portion 410 may be induced into the first housing 810 or the second housing 820 through the protection members 901 and 902. Through the first housing 810 or the second housing 820, the static electricity may be discharged by flowing to a ground of the electronic device 101. In case that the static electricity is generated by friction between the protection members 901 and 902, the static electricity may be discharged through the conductive portion 410, the conductive adhesive layer 431, the protection members 901 and 902, and the first housing 810 or the second housing 820. As the static electricity is discharged, performance deterioration of the electronic device 101 due to the static electricity may be reduced.

According to an aspect of the present disclosure, there is provided an electronic device (101) comprising: a housing (201); a display (230) including a first area (230a), and a second area (230b) at least partially bendable into the housing (201); and a foreign matter prevention part (401) coupled to the housing (201), and disposed between a surface (231) of the second area (230b) for displaying visual information and the housing (201), wherein the foreign matter prevention part (401) includes: a surface (4011) coupled to the housing (201), another surface (4012) opposite to the surface (4011) of the foreign matter prevention part (401) and contacted with the surface (231) of the second area (230b), and a conductive portion (410) electrically connected to the housing (201) to discharge static electricity. For example, the static electricity due to friction between the second area and the foreign matter prevention part may be generated. For example, the static electricity generated outside the electronic device may induce into the gap between the display and the housing. The static electricity may deteriorate performance of the electronic device. The foreign matter prevention part may reduce the inflow of foreign matter into the gap by contacting the second area, and may reduce performance deterioration of the electronic device by discharging the static electricity generated by contact.

In an embodiment, the housing (201) includes a first housing (210) and a second housing (220) slidably coupled to the first housing (210), and the second area (230b) of the display (230) is configured to be at least partially rolled into the first housing (210), based on a sliding movement of the second housing (220). The electronic device may be referred to as a rollable electronic device. The electronic device may provide a variety of user experiences to a user by adjusting a size of the housing and a size of a display area of the display.

In an embodiment, a position of the second area (230b) is changed, based on the sliding movement of the second housing (220), and the conductive portion (410) is electrically connected to the housing (201) and configured to discharge the static electricity. For example, when the sliding movement of the second housing, the second area may move in a state of contacting the foreign matter prevention part. Static electricity generated by a frictional force between the second area and the foreign matter prevention part may be discharged through the foreign matter prevention part.

In an embodiment, the foreign matter prevention part (401) further includes: a non-conductive portion (420) different from the conductive portion (410), and at least one adhesive layer (430) coupling the non-conductive portion (420) and the conductive portion (410) to the housing (201). For example, the at least one adhesive layer may fasten the foreign matter prevention part to the housing.

In an embodiment, the conductive portion (410) is electrically connected to the housing (201) through the conductive adhesive layer (431) of the at least one adhesive layer (430). For example, the conductive adhesive layer may include a conductive material. The conductive adhesive layer may electrically connect the conductive portion to the housing by being disposed between the conductive portion and the housing. Static electricity induced through the conductive portion may flow through the housing to ground.

In an embodiment, the foreign matter prevention part (401) further includes a non-conductive portion (420) different from the conductive portion (410), the non-conductive portion (420) contacts the surface (231) in the second area (230b), and the conductive portion (410) is spaced apart from the surface (231) in the second area (230b). For example, in order for the non-conductive portion to reduce the inflow of foreign matter through the gap between the second area and the housing, the non-conductive portion may contact the one surface in the second area.

In an embodiment, the electronic device (101) further comprises a wireless communication circuit (192) configured to communicate with an external electronic device through a portion of the housing (201), the foreign matter prevention part (401) includes: a first portion (401a) corresponding to the portion of the housing (201), and a second portion (401b) corresponding to another portion of the housing (201) different from the portion of the housing (201), and wherein the conductive portion (410) is included in the second portion (401b) of the first portion (401a) and the second portion (401b). For example, in case that the conductive portion is electrically connected to a portion of the housing operating as an antenna, the wireless communication performance of the electronic device may be deteriorated. In order to reduce the deterioration of the wireless communication performance of the electronic device, the conductive portion may not be disposed in a portion of the housing, but may be disposed in the other portion different from the portion of the housing.

In an embodiment, the housing (201) comprises: a first surface (210-1) facing a direction in which the first area (230a) faces, a second surface (210-2) perpendicular to the first surface (210-1), a first conductive portion (210a), a second conductive portion (210b), and a third conductive portion (210c) forming the first surface (210-1) and the second surface (210-2), a first non-conductive portion (210d) disposed between the first conductive portion (210a) and the third conductive portion (210c), and a second non-conductive portion (210e) disposed between the second conductive portion (210b) and the third conductive portion (210c), and wherein the electronic device (101) further comprises a wireless communication circuit (192) configured to communicate with an external electronic device by feeding the third conductive portion (210c).

In an embodiment, the foreign matter prevention part (401) includes: a first portion (401a) corresponding to the third conductive portion of the housing (201), and a second portion (401b) corresponding to another portion of the housing (201) different from the portion of the housing (201), and the conductive portion (410) is included in the second portion (401b) of the first portion (401a) and the second portion (401b). For example, the non-conductive portion may be disposed in the first portion and the second portion, and the conductive portion may be disposed only in the second portion. The non-conductive portion may reduce the inflow of the foreign matter into the gap between the second area and the housing. By disposing the conductive portion only in the second portion, deterioration in communication performance of the electronic device may be reduced.

In an embodiment, the foreign matter prevention part (401) further includes: a non-conductive portion (420) different from the conductive portion (410), and a non-conductive adhesive layer (432) coupling the non-conductive portion (420) to the housing (201), and a conductive adhesive layer (431) coupling the conductive portion (410) to the housing (201), the non-conductive adhesive layer (432) is coupled to the second conductive portion (210b), and the conductive adhesive layer (431) is coupled to the first conductive portion (210a) and the third conductive portion (210c). For example, by not including a conductive adhesive layer in the third conductive portion operating as the antenna, the deterioration in the communication performance of the electronic device may be reduced.

In an embodiment, the first conductive portion (210a) and the second conductive portion (210b) are electrically connected to a ground of the electronic device (101), and wherein the conductive portion (410) is configured to discharge static electricity by inducing the static electricity to the ground. According to an example, a first conductive area and a second conductive area may be electrically connected to the ground of the electronic device. The first conductive area and the second conductive area may be electrically connected to the ground of the electronic device through a sub-PCB (e.g., a sub-PCB 327 of FIG. 3A). Since the first conductive area and the second conductive area are electrically connected to the ground of the electronic device, they may be grounded. Static electricity generated by contact between the second area and the foreign matter prevention part may be discharged by flowing to the ground. As the static electricity is discharged, performance deterioration of the electronic device may be reduced.

In an embodiment, the housing (201) includes a recess (214) for accommodating the second area (230b), and the foreign matter prevention part (401) is disposed at a position where the second area (230b) is rolled into the recess (214). For example, the foreign matter prevention part may reduce the inflow of the foreign matter into the gap between the second area and the housing by being disposed at the position where the second area is rolled into the recess.

In an embodiment, a shape of the foreign matter prevention part (401) corresponds to a shape of the second area (230b) in a state in which the second area (230b) is rolled into the housing (201). For example, the shape of the foreign matter prevention part may correspond to the curved shape of the second area. Since the shape of the foreign matter prevention part corresponds to the shape of the second area, the inflow of the foreign matter into the gap may be reduced, and even if the second area moves in a state of contacting the foreign matter prevention part, the second area may not be damaged.

In an embodiment, the foreign matter prevention part (401) further includes a non-conductive portion (420) different from the conductive portion (410), and the non-conductive portion (420) includes a non-conductive fiber. Since the non-conductive portion including the non-conductive fibers is not rigid and is soft, damage to the second area may be reduced even if it contacts the second area.

In an embodiment, the conductive portion (410) includes a conductive fiber. For example, as the conductive fibers induce static electricity to the housing, the static electricity may be discharged.

An electronic device (e.g., the electronic device 101 of FIG. 5A) is provided. The electronic device may comprise a first housing (e.g., the first housing 210 of FIG. 5A), a second housing (e.g., the second housing 220 of FIG. 5A), a display (e.g., the display 230 of FIG. 5A), and a foreign matter prevention part (e.g., the foreign matter prevention part 401 of FIG. 5A). The second housing may be slidably coupled to the first housing. The display may include one surface (e.g., a surface 231 of FIG. 5A) for displaying visual information and another surface (e.g., another surface 232 of FIG. 5A) opposite to the one surface. The display may include an area (e.g., the second area 230b of FIG. 5A) at least partially rolled into the housing, based on a slide movement of the second housing. The foreign matter prevention part may be disposed between the one surface in the area and the first housing, in a state in which the area is rolled into the first housing. The foreign matter prevention part may reduce the inflow of the foreign matter through the gap between the display and the first housing, by being coupled to the first housing. The foreign matter prevention part may include a conductive portion (e.g., the conductive portion 420 of FIG. 6) and non-conductive portion (e.g., the non-conductive portion 420 of FIG. 6). The conductive portion may be electrically connected to the housing so that static electricity is discharged.

According to an example, the foreign matter prevention part may further comprise at least one adhesive layer (e.g., at least one adhesive layer 430 of FIG. 6) coupling the non-conductive portion and the conductive portion to the housing. The conductive portion may be electrically connected to the housing through the conductive adhesive layer (e.g., the conductive adhesive layer 431 of FIG. 6) of the at least one adhesive layer.

According to an example, the non-conductive portion may contact the one surface in the area. The conductive portion may be space apart from the one surface in the area.

The electronic device according to an example may further comprise a wireless communication circuit (e.g., the wireless communication module 192 of FIG. 1) configured to communicate with an external electronic device through a portion of the first housing. The conductive portion may be disposed in a second portion of the foreign matter prevention part corresponding to another portion different from the portion of the first housing. According to an example, the first housing may comprise a first surface (e.g., a first surface 210-1 of FIG. 7A) facing the direction in which the first area faces and a second surface (e.g., a second surface 210-2 of FIG. 7A) substantially perpendicular to the first surface. The first housing may comprise a first conductive portion (e.g., the first conductive portion 210a of FIG. 7A), a second conductive portion (e.g., the second conductive portion 210b of FIG. 7A), and a third conductive portion (e.g., the third conductive portion 210c of FIG. 7A) forming the first surface and the second surface. The first housing may comprise a first non-conductive portion (e.g., the first non-conductive portion 210d of FIG. 7A) disposed between the first conductive portion and the third conductive portion and a second non-conductive portion (e.g., the second non-conductive portion 210e of FIG. 7A) disposed between the second conductive portion and the third conductive portion. The electronic device may further comprise a wireless communication circuit configured to communicate with an external electronic device by feeding the third conductive portion.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, the term "or" is an inclusive term, meaning or, unless specified otherwise. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device (101) comprising:
a housing (201);
a display (230) including a first area (230a), and a second area (230b) at least partially bendable into the housing (201); and
a foreign matter prevention part (401) coupled to the housing (201), and disposed between a surface (231) of the second area (230b) for displaying visual information and the housing (201),
wherein the foreign matter prevention part (401) includes:
a first surface (4011) coupled to the housing (201),
a second surface (4012) opposite to the first surface (4011) of the foreign matter prevention part (401) and contacted with the surface (231) of the second area (230b), and
a conductive portion (410) electrically connected to the housing (201) to discharge static electricity.

2. The electronic device (101) of claim 1,
wherein the housing (201) includes a first housing (210) and a second housing (220) slidably coupled to the first housing (210), and
wherein the second area (230b) of the display (230) is configured to be at least partially rolled into the first housing (210), based on a sliding movement of the second housing (220).

3. The electronic device (101) of claim 2,
wherein a position of the second area (230b) is changed, based on the sliding movement of the second housing (220), and
wherein the conductive portion (410) is electrically connected to the housing (201) and configured to discharge the static electricity.

4. The electronic device (101) of any one of claims 1 to 3,
wherein the foreign matter prevention part (401) further includes:
a non-conductive portion (420) different from the conductive portion (410), and
at least one adhesive layer (430) coupling the non-conductive portion (420) and the conductive portion (410) to the housing (201).

5. The electronic device (101) of claim 4,
wherein the conductive portion (410) is electrically connected to the housing (201) through the conductive adhesive layer (431) of the at least one adhesive layer (430).

6. The electronic device (101) of any one of claims 1 to 5,
wherein the foreign matter prevention part (401) further includes a non-conductive portion (420) different from the conductive portion (410),
wherein the non-conductive portion (420) contacts the surface (231) in the second area (230b), and
wherein the conductive portion (410) is spaced apart from the surface (231) in the second area (230b).

7. The electronic device (101) of any one of claims 1 to 6, further comprises a wireless communication circuit (192) configured to communicate with an external electronic device through a portion of the housing (201),
wherein the foreign matter prevention part (401) includes:
a first portion (401a) corresponding to the portion of the housing (201), and
a second portion (401b) corresponding to another portion of the housing (201) different from the portion of the housing (201), and
wherein the conductive portion (410) is included in the second portion (401b) of the first portion (401a) and the second portion (401b).

8. The electronic device (101) of any one of claims 1 to 7,
wherein the housing (201) comprises:
a first surface (210-1) facing a direction in which the first area (230a) faces,
a second surface (210-2) perpendicular to the first surface (210-1) of the housing (201),
a first conductive portion (210a), a second conductive portion (210b), and a third conductive portion (210c) forming the first surface (210-1) of the housing (201) and the second surface (210-2) of the housing (201),
a first non-conductive portion (210d) disposed between the first conductive portion (210a) and the third conductive portion (210c), and
a second non-conductive portion (210e) disposed between the second conductive portion (210b) and the third conductive portion (210c), and
wherein the electronic device (101) further comprises a wireless communication circuit (192) configured to communicate with an external electronic device by feeding the third conductive portion (210c).

9. The electronic device (101) of claim 8,
wherein the foreign matter prevention part (401) includes:
a first portion (401a) corresponding to the third conductive portion of the housing (201), and
a second portion (401b) corresponding to another portion of the housing (201) different from the portion of the housing (201), and
wherein the conductive portion (410) is included in the second portion (401b) of the first portion (401a) and the second portion (401b).

10. The electronic device (101) of claim 8 or 9,
wherein the foreign matter prevention part (401) further includes:
a non-conductive portion (420) different from the conductive portion (410), and
a non-conductive adhesive layer (432) coupling the non-conductive portion (420) to the housing (201), and
a conductive adhesive layer (431) coupling the conductive portion (410) to the housing (201),
wherein the non-conductive adhesive layer (432) is coupled to the second conductive portion (210b), and
wherein the conductive adhesive layer (431) is coupled to the first conductive portion (210a) and the third conductive portion (210c).

11. The electronic device (101) of any one of claims 8 to 10,
wherein the first conductive portion (210a) and the second conductive portion (210b) are electrically connected to a ground of the electronic device (101), and
wherein the conductive portion (410) is configured to discharge static electricity by inducing the static electricity to the ground.

12. The electronic device (101) of any one of claims 1 to 11,
wherein the housing (201) includes a recess (214) for accommodating the second area (230b), and
wherein the foreign matter prevention part (401) is disposed at a position where the second area (230b) is rolled into the recess (214).

13. An electronic device (101) of any one of claims 1 to 12,
wherein a shape of the foreign matter prevention part (401) corresponds to a shape of the second area (230b) in a state in which the second area (230b) is rolled into the housing (201).

14. An electronic device (101) of any one of claims 1 to 13,
wherein the foreign matter prevention part (401) further includes a non-conductive portion (420) different from the conductive portion (410), and
wherein the non-conductive portion (420) includes a non-conductive fiber.

15. An electronic device (101) of any one of claims 1 to 14,
wherein the conductive portion (410) includes a conductive fiber.

## Patentansprüche

1. Elektronische Vorrichtung (101), umfassend:
ein Gehäuse (201);
eine Anzeige (230), beinhaltend einen ersten Bereich (230a) und einen zweiten Bereich (230b), die mindestens teilweise in das Gehäuse (201) biegbar sind; und
eine Struktur zur Verhinderung von Fremdstoffen (401), die an das Gehäuse (201) gekoppelt ist und zwischen einer Oberfläche (231) des zweiten Bereichs (230b) zum Anzeigen visueller Informationen und dem Gehäuse (201) angeordnet ist,
wobei die Struktur zur Verhinderung von Fremdstoffen (401) Folgendes beinhaltet:
eine erste Oberfläche (4011), die an das Gehäuse (201) gekoppelt ist,
eine zweite Oberfläche (4012) gegenüber der ersten Oberfläche (4011) der Struktur zur Verhinderung von Fremdstoffen (401) und in Kontakt mit der Oberfläche (231) des zweiten Bereichs (230b) und
einen leitfähigen Abschnitt (410), der elektrisch mit dem Gehäuse (201) verbunden ist, um statische Elektrizität abzuleiten.

2. Elektronische Vorrichtung (101) nach Anspruch 1,
wobei das Gehäuse (201) ein erstes Gehäuse (210) und ein zweites Gehäuse (220), das verschiebbar an das erste Gehäuse (210) gekoppelt ist, beinhaltet, und
wobei der zweite Bereich (230b) der Anzeige (230) dazu konfiguriert ist, basierend auf einer Gleitbewegung des zweiten Gehäuses (220) mindestens teilweise in das erste Gehäuse (210) gerollt zu werden.

3. Elektronische Vorrichtung (101) nach Anspruch 2,
wobei eine Position des zweiten Bereichs (230b) basierend auf der Gleitbewegung des zweiten Gehäuses (220) geändert wird und
wobei der leitfähige Abschnitt (410) elektrisch mit dem Gehäuse (201) verbunden und dazu konfiguriert ist, die statische Elektrizität abzuleiten.

4. Elektronische Vorrichtung (101) nach einem der Ansprüche 1 bis 3,
wobei die Struktur zur Verhinderung von Fremdstoffen (401) ferner Folgendes beinhaltet:
einen nicht leitfähigen Abschnitt (420), der sich von dem leitfähigen Abschnitt (410) unterscheidet, und
mindestens eine Klebeschicht (430), die den nicht leitfähigen Abschnitt (420) und den leitfähigen Abschnitt (410) an das Gehäuse (201) koppelt.

5. Elektronische Vorrichtung (101) nach Anspruch 4,
wobei der leitfähige Abschnitt (410) elektrisch mit dem Gehäuse (201) durch die leitfähige Klebeschicht (431) der mindestens einen Klebeschicht (430) verbunden ist.

6. Elektronische Vorrichtung (101) nach einem der Ansprüche 1 bis 5,
wobei die Struktur zur Verhinderung von Fremdstoffen (401) ferner einen nicht leitfähigen Abschnitt (420) beinhaltet, der sich von dem leitfähigen Abschnitt (410) unterscheidet,
wobei der nicht leitfähige Abschnitt (420) die Oberfläche (231) in dem zweiten Bereich (230b) berührt, und
wobei der leitfähige Abschnitt (410) von der Oberfläche (231) in dem zweiten Bereich (230b) beabstandet ist.

7. Elektronische Vorrichtung (101) nach einem der Ansprüche 1 bis 6, die ferner eine drahtlose Kommunikationsschaltung (192) umfasst, die dazu konfiguriert ist, mit einer externen elektronischen Vorrichtung durch einen Abschnitt des Gehäuses (201) zu kommunizieren,
wobei die Struktur zur Verhinderung von Fremdstoffen (401) Folgendes beinhaltet:
einen ersten Abschnitt (401a), der dem Abschnitt des Gehäuses (201) entspricht, und
einen zweiten Abschnitt (401b), der einem anderen Abschnitt des Gehäuses (201) entspricht, der sich von dem Abschnitt des Gehäuses (201) unterscheidet, und
wobei der leitfähige Abschnitt (410) in dem zweiten Abschnitt (401b) des ersten Abschnitts (401a) und des zweiten Abschnitts (401b) beinhaltet ist.

8. Elektronische Vorrichtung (101) nach einem der Ansprüche 1 bis 7,
wobei das Gehäuse (201) Folgendes umfasst:
eine erste Oberfläche (210-1), die einer Richtung zugewandt ist, welcher der erste Bereich (230a) zugewandt ist,
eine zweite Oberfläche (210-2) senkrecht zu der ersten Oberfläche (210-1) des Gehäuses (201),
einen ersten leitfähigen Abschnitt (210a), einen zweiten leitfähigen Abschnitt (210b) und einen dritten leitfähigen Abschnitt (210c), die die erste Oberfläche (210-1) des Gehäuses (201) und die zweite Oberfläche (210-2) des Gehäuses (201) bilden,
einen ersten nicht leitfähigen Abschnitt (210d), der zwischen dem ersten leitfähigen Abschnitt (210a) und dem dritten leitfähigen Abschnitt (210c) angeordnet ist, und
einen zweiten nicht leitfähigen Abschnitt (210e), der zwischen dem zweiten leitfähigen Abschnitt (210b) und dem dritten leitfähigen Abschnitt (210c) angeordnet ist, und
wobei die elektronische Vorrichtung (101) ferner eine drahtlose Kommunikationsschaltung (192) umfasst, die dazu konfiguriert ist, mit einer externen elektronischen Vorrichtung durch Zuführen des dritten leitfähigen Abschnitts (210c) zu kommunizieren.

9. Elektronische Vorrichtung (101) nach Anspruch 8,
wobei die Struktur zur Verhinderung von Fremdstoffen (401) Folgendes beinhaltet:
einen ersten Abschnitt (401a), der dem dritten leitfähigen Abschnitt des Gehäuses (201) entspricht, und
einen zweiten Abschnitt (401b), der einem anderen Abschnitt des Gehäuses (201) entspricht, der sich von dem Abschnitt des Gehäuses (201) unterscheidet, und
wobei der leitfähige Abschnitt (410) in dem zweiten Abschnitt (401b) des ersten Abschnitts (401a) und des zweiten Abschnitts (401b) beinhaltet ist.

10. Elektronische Vorrichtung (101) nach Anspruch 8 oder 9,
wobei die Struktur zur Verhinderung von Fremdstoffen (401) ferner Folgendes beinhaltet:
einen nicht leitfähigen Abschnitt (420), der sich von dem leitfähigen Abschnitt (410) unterscheidet, und
eine nicht leitfähige Klebeschicht (432), die den nicht leitfähigen Abschnitt (420) an das Gehäuse (201) koppelt, und
eine leitfähige Klebeschicht (431), die den leitfähigen Abschnitt (410) an das Gehäuse (201) koppelt,
wobei die nicht leitfähige Klebeschicht (432) an den zweiten leitfähigen Abschnitt (210b) gekoppelt ist, und
wobei die leitfähige Klebeschicht (431) an den ersten leitfähigen Abschnitt (210a) und den dritten leitfähigen Abschnitt (210c) gekoppelt ist.

11. Elektronische Vorrichtung (101) nach einem der Ansprüche 8 bis 10,
wobei der erste leitfähige Abschnitt (210a) und der zweite leitfähige Abschnitt (210b) elektrisch mit einer Erde der elektronischen Vorrichtung (101) verbunden sind, und
wobei der leitfähige Abschnitt (410) dazu konfiguriert ist, statische Elektrizität abzuleiten, indem die statische Elektrizität zur Erde induziert wird.

12. Elektronische Vorrichtung (101) nach einem der Ansprüche 1 bis 11,
wobei das Gehäuse (201) eine Aussparung (214) zum Aufnehmen des zweiten Bereichs (230b) beinhaltet, und
wobei die Struktur zur Verhinderung von Fremdstoffen (401) an einer Position angeordnet ist, an welcher der zweite Bereich (230b) in die Aussparung (214) gerollt ist.

13. Elektronische Vorrichtung (101) nach einem der Ansprüche 1 bis 12,
wobei eine Gestalt der Struktur zur Verhinderung von Fremdstoffen (401) einer Gestalt des zweiten Bereichs (230b) in einem Zustand entspricht, in dem der zweite Bereich (230b) in das Gehäuse (201) gerollt ist.

14. Elektronische Vorrichtung (101) nach einem der Ansprüche 1 bis 13,
wobei die Struktur zur Verhinderung von Fremdstoffen (401) ferner einen nicht leitfähigen Abschnitt (420) beinhaltet, der sich von dem leitfähigen Abschnitt (410) unterscheidet, und
wobei der nicht leitfähige Abschnitt (420) eine nicht leitfähige Faser beinhaltet.

15. Elektronische Vorrichtung (101) nach einem der Ansprüche 1 bis 14,
wobei der leitfähige Abschnitt (410) eine leitfähige Faser beinhaltet.

## Revendications

1. Dispositif électronique (101) comprenant :
un boîtier (201) ;
un affichage (230) comprenant une première zone (230a), et une seconde zone (230b) au moins partiellement pliable dans le boîtier (201) ; et
une pièce de prévention de matière étrangère (401) couplée au boîtier (201), et disposée entre une surface (231) de la seconde zone (230b) destinée à afficher des informations visuelles et le boîtier (201),
dans lequel la pièce de prévention de matière étrangère (401) comprend :
une première surface (4011) couplée au boîtier (201),
une seconde surface (4012) opposée à la première surface (4011) de la pièce de prévention de matière étrangère (401) et en contact avec la surface (231) de la seconde zone (230b), et
une partie conductrice (410) reliée électriquement au boîtier (201) pour décharger de l'électricité statique.

2. Dispositif électronique (101) de la revendication 1,
dans lequel le boîtier (201) comprend un premier boîtier (210) et un second boîtier (220) couplé de manière coulissante au premier boîtier (210), et
dans lequel la seconde zone (230b) de l'affichage (230) est conçue pour être au moins partiellement enroulée dans le premier boîtier (210), sur la base d'un mouvement de coulissement du second boîtier (220).

3. Dispositif électronique (101) de la revendication 2,
dans lequel une position de la seconde zone (230b) est modifiée, sur la base du mouvement de coulissement du second boîtier (220), et
dans lequel la partie conductrice (410) est reliée électriquement au boîtier (201) et est conçue pour décharger de l'électricité statique.

4. Dispositif électronique (101) de l'une quelconque des revendications 1 à 3,
dans lequel la pièce de prévention de matière étrangère (401) comprend en outre :
une partie non conductrice (420) différente de la partie conductrice (410), et
au moins une couche adhésive (430) couplant la partie non conductrice (420) et la partie conductrice (410) au boîtier (201).

5. Dispositif électronique (101) de la revendication 4,
dans lequel la partie conductrice (410) est reliée électriquement au boîtier (201) au travers de la couche adhésive conductrice (431) de l'au moins une couche adhésive (430).

6. Dispositif électronique (101) de l'une quelconque des revendications 1 à 5,
dans lequel la pièce de prévention de matière étrangère (401) comprend en outre une partie non conductrice (420) différente de la partie conductrice (410),
dans lequel la partie non conductrice (420) est en contact avec la surface (231) dans la seconde zone (230b), et
dans lequel la partie conductrice (410) est espacée de la surface (231) dans la seconde zone (230b).

7. Dispositif électronique (101) de l'une quelconque des revendications 1 à 6, comprenant en outre un circuit de communication sans fil (192) conçu pour communiquer avec un dispositif électronique externe au travers d'une partie du boîtier (201),
dans lequel la pièce de prévention de matière étrangère (401) comprend :
une première partie (401a) correspondant à la partie du boîtier (201), et
une seconde partie (401b) correspondant à une autre partie du boîtier (201) différente de la partie du boîtier (201), et
dans lequel la partie conductrice (410) est comprise dans la seconde partie (401b) de la première partie (401a) et de la seconde partie (401b).

8. Dispositif électronique (101) de l'une quelconque des revendications 1 à 7,
dans lequel le boîtier (201) comprend :
une première surface (210-1) faisant face à une direction où est orientée la première zone (230a),
une seconde surface (210-2) perpendiculaire à la première surface (210-1) du boîtier (201),
une première partie conductrice (210a), une deuxième partie conductrice (210b) et une troisième partie conductrice (210c) formant la première surface (210-1) du boîtier (201) et la seconde surface (210-2) du boîtier (201),
une première partie non conductrice (210d) disposée entre la première partie conductrice (210a) et la troisième partie conductrice (210c), et
une seconde partie non conductrice (210e) disposée entre la deuxième partie conductrice (210b) et la troisième partie conductrice (210c), et
dans lequel le dispositif électronique (101) comprend en outre un circuit de communication sans fil (192) conçu pour communiquer avec un dispositif électronique externe en alimentant la troisième partie conductrice (210c).

9. Dispositif électronique (101) de la revendication 8,
dans lequel la pièce de prévention de matière étrangère (401) comprend :
une première partie (401a) correspondant à la troisième partie conductrice du boîtier (201), et
une seconde partie (401b) correspondant à une autre partie du boîtier (201) différente de la partie du boîtier (201), et
dans lequel la partie conductrice (410) est comprise dans la seconde partie (401b) de la première partie (401a) et de la seconde partie (401b).

10. Dispositif électronique (101) de la revendication 8 ou 9,
dans lequel la pièce de prévention de matière étrangère (401) comprend en outre :
une partie non conductrice (420) différente de la partie conductrice (410), et
une couche adhésive non conductrice (432) couplant la partie non conductrice (420) au boîtier (201), et
une couche adhésive conductrice (431) couplant la partie conductrice (410) au boîtier (201),
dans lequel la couche adhésive non conductrice (432) est couplée à la deuxième partie conductrice (210b), et
dans lequel la couche adhésive conductrice (431) est couplée à la première partie conductrice (210a) et à la troisième partie conductrice (210c).

11. Dispositif électronique (101) de l'une quelconque des revendications 8 à 10,
dans lequel la première partie conductrice (210a) et la deuxième partie conductrice (210b) sont électriquement reliées à une masse du dispositif électronique (101), et
dans lequel la partie conductrice (410) est conçue pour décharger de l'électricité statique en induisant de l'électricité statique vers la masse.

12. Dispositif électronique (101) de l'une quelconque des revendications 1 à 11,
dans lequel le boîtier (201) comprend un évidement (214) destiné à recevoir la seconde zone (230b), et
dans lequel la pièce de prévention de matière étrangère (401) est disposée au niveau d'une position où la seconde zone (230b) est enroulée dans l'évidement (214).

13. Dispositif électronique (101) de l'une quelconque des revendications 1 à 12,
dans lequel une forme de la pièce de prévention de matière étrangère (401) correspond à une forme de la seconde zone (230b) dans un état où la seconde zone (230b) est enroulée dans le boîtier (201).

14. Dispositif électronique (101) de l'une quelconque des revendications 1 à 13,
dans lequel la pièce de prévention de matière étrangère (401) comprend en outre une partie non conductrice (420) différente de la partie conductrice (410), et
dans lequel la partie non conductrice (420) comprend une fibre non conductrice.

15. Dispositif électronique (101) de l'une quelconque des revendications 1 à 14,
dans lequel la partie conductrice (410) comprend une fibre conductrice.
